(19) Europäisches Patentamt
European Patent Office
Office européen des brevets

(11) EP 0 848 293 B1

(12) EUROPEAN PATENT SPECIFICATION

(45) Date of publication and mention of the grant of the patent:
**03.07.2002 Bulletin 2002/27**

(51) Int Cl.[7]: **G03F 7/027**, G03F 7/029, G03C 9/08

(21) Application number: **97203870.7**

(22) Date of filing: **09.12.1997**

# (54) Photo-curable resin composition

Photohärtbare Harzzusammensetzung

Composition de résine photodurcissable

(84) Designated Contracting States:
**CH DE FR GB IT LI NL**

(30) Priority: **10.12.1996 JP 32930496**

(43) Date of publication of application:
**17.06.1998 Bulletin 1998/25**

(73) Proprietors:
- **DSM N.V.**
  **6411 TE Heerlen (NL)**
- **JAPAN SYNTHETIC RUBBER CO., LTD.**
  **Tokyo 104 (JP)**
- **Japan Fine Coatings Co., Ltd.**
  **Tokyo 104-8410 (JP)**

(72) Inventors:
- **Watanabe, Tsuyoshi**
  **Tsukuba, Ibaraki 305 (JP)**
- **Yamamura, Tetsuya**
  **Tsukuba, Ibaraki 305 (JP)**
- **Haruta, Yuichi**
  **Tsuchiura, Ibaraki 300 (JP)**
- **Ukachi, Takashi**
  **Ushiku, Ibaraki 300-12 (JP)**

(74) Representative:
**den Hartog, Jeroen Hendrikus Joseph et al**
**DSM Patents & Trademarks**
**Office Geleen**
**P.O. Box 9**
**6160 MA Geleen (NL)**

(56) References cited:
**WO-A-97/38354**
**US-A- 5 476 748**
**US-A- 5 502 083**

- **PATENT ABSTRACTS OF JAPAN vol. 014, no. 261 (C-0725), 6 June 1990 & JP 02 075618 A (ASAHI DENKA KOGYO KK), 15 March 1990,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 848 293 B1

## Description

FIELD OF THE INVENTION

The present invention relates to a photo-curable resin composition, especially to a liquid photo-curable resin composition suitable as material used in photo-fabrication processes.

BACKGROUND OF THE INVENTION

In recent years, photo-fabrication processes for forming three-dimensional objects consisting of integrally laminated cured resin layers prepared by repeating a step of forming a cured resin layer by selectively irradiating a liquid photo-curable material with light have been the subject of much development (see Japanese Patent Application Laid-open No. 247515/1985, USP No. 4,575,330 (Japanese Patent Application Laid-open No. 35966/1987), Japanese Patent Application Laid-open No. 101408/1987, Japanese Patent Application Laid-open No. 24119/1993).

A typical example of such a photo-fabrication process comprises forming a curable resin layer having a specified pattern by selectively irradiating with light using, for example, an ultraviolet radiation laser on the surface of a liquid photo-curable material (photo-curable resin composition), feeding the photo-curable resin composition equivalent to one layer to form another thin layer of the composition over this cured resin layer, and selectively irradiating this thin layer with light to form a new cured resin layer which is integrally laminated over the previously formed cured resin layer. This step is repeated a number of times, with or without changing the pattern in which the light is irradiated to form a three-dimensional object consisting of integrally laminated multiple cured resin layers. This photo-fabrication process has been attracting considerable attention, because the target three-dimensional object can easily be prepared in a short period of time even if it has a complicated shape.

The following resin compositions (A) to (C) represent photo-curable resin composition used in the photo-fabrication process.

(A) Resin compositions containing a radical polymerizable organic compound such as urethane (meth)acrylate, oligoester(meth)acrylate, epoxy(meth)acrylate, thiol-ene compounds, photosensitive polyimide, and the like (see Japanese Patent Applications Laid-open No. 204915/1989, No. 208305/1990, and No. 160013/1991).

(B) Resin compositions containing a cationic polymerizable organic compound such as an epoxy compound, cyclic ether compound, cyclic lactone compound, cyclic acetal compound, cyclic thioether compound, spiro-orthoester compound, vinylether compound, and the like (see Japanese Patent Application Laid-open No. 213304/1989).

(C) Resin compositions containing a radical polymerizable organic compound and a cationic polymerizable organic compound(see Japanese Patent Applications Laid-open No. 28261/1990, No. 75618/1990, and No. 228413/1994).

The characteristics required of the photo-curable resin composition used for these photo-fabrication processes include a low viscosity to form a smooth liquid level and the capability of being rapidly cured by irradiation of light. Also, the required characteristics of the photo-curable resin composition are minimal swelling of the cured products and minimal deformation due to shrinkage during curing with light, so as to minimize the production of defective parts such as warped parts, indented parts (sinkmark), or stretched parts (overhanging parts).

US 5,502,083 describes coating compositions comprising onium salts, which are part of a photopolymerization initiator. These coating compositions are not applied for the formation of three-dimensional objects.

US 5,476,748 describes photosensitive compositions comprising the following elements: an epoxy resin having an epoxy functionality of equal or greater than 2, a cationic photoinitiator, a diacrylate, a polyacrylate with functionality >2, a radical photoinitiator and an OH-terminated polyether, polyester or polyurethane. These photosensitive compositions do not disclose the photoinitiator of the present invention.

Three-dimensional objects prepared by photo-fabrication methods have conventionally been used for design models and trial mechanical parts. In order to use this process for trial mechanical parts, it is important that the three-dimensional object has high dimensional accuracy in accordance with the design in fine processing, mechanical strength and heat resistance sufficient to withstand conditions of use. However, no conventional resin composition However, no conventional resin composition can satisfy the above demands. When the conventional resin compositions are applied in the photo-fabrication process, considerable energy is required for preparing a three-dimensional object so that photo-fabrication cannot be efficiently implemented in a short time. The three-dimensional objects obtained exhibit problems of deformation with the passage of time, resulting in problems such as production of warped parts, or indented parts, or stretched parts (overhanging parts), because of residual strain due to the shrinkage during curing. These problems of deformation with the passage of time can be partly solved by the correction of the input data to the CAD. However, CAD corrections are insufficient to compensate for modern trial mechanical parts which have intricate and complicated shapes or to circumstantial variations of use.

Mechanical characteristics of three-dimensional objects prepared by photo-fabrication by using conventional resin compositions containing an epoxy compound are degraded in the course of time in accordance with environmental conditions such as temperature and humidity. Therefore, use of these three-dimensional objects is unsuitable for the application requiring mechanical strength over an extended period of time.

Also, no three-dimensional object prepared by using the conventional resin compositions is provided with mechanical strength, dimensional accuracy, heat resistance, moisture resistance, water resistance, and the like demanded of modern trial mechanical parts.

The present invention has been achieved in view of this problem and has an object of providing a novel photo-curable resin composition.

Another object of the present invention is to provide a photo-curable resin composition capable of being rapidly cured by radiation of light and providing three-dimensional objects in an efficient manner.

Still another object of the present invention is to provide a photo-curable resin composition capable of being fabricated to produce three-dimensional objects which have mechanical strength and high dimensional accuracy and are suitable for trial mechanical parts.

A further object of the present invention is to provide a photo-curable resin composition which can be fabricated to produce three-dimensional objects provided with lasting minimal deformation characteristics.

A still further object of the present invention is to provide a photo-curable resin composition which can be fabricated to produce a three-dimensional object provided with lasting minimal degradation in mechanical characteristics.

## SUMMARY OF THE INVENTION

The above objects as well as others that will become apparent upon understanding the present invention can be attained by a photo-fabrication employing photo-curable resin composition comprising,

(A) a cyclohexene oxide compound,
(B) a glycidyl ether compound,
(C) an onium salt represented by formula (1),
(D) an ethylenically unsaturated monomer,
(E) a radical photo-initiator, and
(F) a polyol having three or more hydroxyl groups

Formula (1):

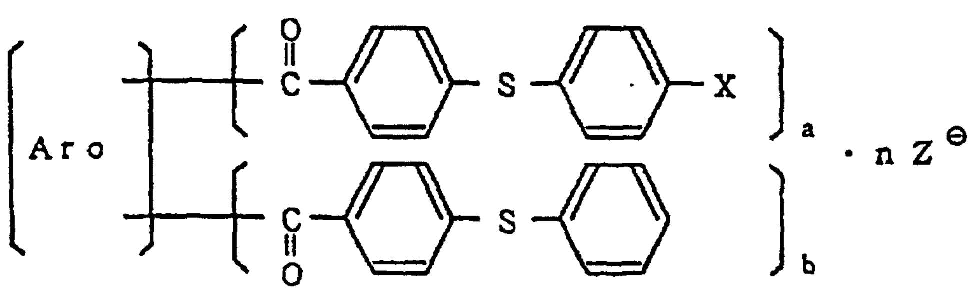

wherein Aro represents an aromatic group with a valence of 1-4, X represents a bisphenylsulfonio group which may contain a substitutional group represented by the following formula (2), and Z represents a halide represented by the following formula (3), a is an integer from 1-4, b is 0 or an integer from 1-3, the sum of a and b is an integer from 1-4, and n is an integer from 1-4.

Formula (2):

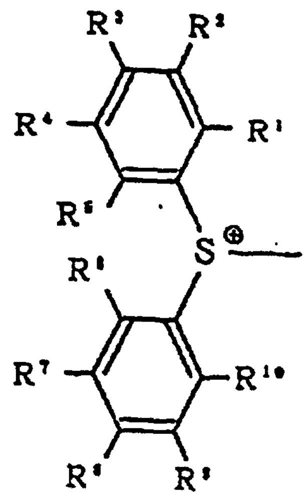

wherein $R^1$-$R^{10}$ independently represent a hydrogen atom, halogen atom, nitro group, alkoxy group, alkyl group, phenyl group which may be substituted by a substitutional group having 6-18 carbon atoms, phenoxy group, phenylcarbonyl group, alkylthio group, phenylthio group, benzyloxy group, aliphatic group having 1-25 carbon atoms and at least one hydroxyl group, or aliphatic group having 3-25 carbon atoms and a group represented by the formula $-OCH_2CH(R^{11})O-$ ($R^{11}$ represents a hydrogen atom or alkyl group).

Formula (3):

$$MQ_m\text{-}(\text{-}OH)_L$$

wherein M is a boron atom, phosphorus atom, arsenic atom, or antimony atom, and Q is a halogen atom, m is an integer from 3-6, L is 0 or 1, and the sum of m+L is an integer from 4-6.

DETAILED DESCRIPTION OF THE INVENTION AND PREFERRED EMBODIMENTS

The present invention will now be explained in detail.

(A) Cyclohexene Oxide Compound

A compound having a cyclohexene oxide structure (herein called cyclohexene oxide compound) which is employed as component A of the photo-curable resin composition of the present invention. This organic compound which can start a polymerization reaction and a cross-linking reaction by the irradiation of light in the presence of a cationic photo-initiator is hereinafter called a cationic polymerizable organic compound.

Typical examples of a compound used as component (A) are
3,4-epoxycyclohexylmethyl-3',4'-epoxycyclohexane carboxylate,
2-(3,4-epoxycyclohexyl-5,5-spiro-3,4-epoxy)cyclohexanemetha-dioxane, bis(3,4-epoxycyclohexylmethyl) adipate, vinyl cyclohexene oxide, 4-vinylepoxycyclohexane,
bis(3,4-epoxy-6-methylcyclohexylmethyl) adipate, 3,4-epoxy-6-methyl
cyclohexyl-3',4'-epoxy-6'-methylcyclohexane carboxylate, methylenebis(3,4-epoxycyclohexane), dicyclopentadiene diepoxide,
di(3,4-epoxycyclohexylmethyl) ether of ethylene glycol, ethylenebis(3,4-epoxycyclohexane carboxylate), lactone modified
3,4-epoxycyclohexylmethyl-3',4'-epoxycyclohexane carboxylate, epoxidated tetrabenzyl alcohol, lactone modified epoxydated tetrahydrobenzyl alcohol, and cyclohexene oxide.

Preferred cyclohexene oxide compounds useful as component (A) are epoxy compounds having two or more alicyclic epoxy groups in one molecule such as 3,4-epoxycyclohexylmethyl-3',4'-epoxycyclohexane carboxylate and

bis(3,4-epoxycyclohexylmethyl) adipate. If these alicyclic epoxy compounds are contained in component (A) in the amount of 50-100% by weight, the cationic polymerization reaction (cure rate) of the resulting resin composition is accelerated so that the fabrication time is minimized and the shrinkage factor from curing is decreased, thereby restraining deformation with time of three-dimensional objects.

Given as examples of the commercially available products of the cyclohexene oxide compound used as component (A) are UVR-6100, UVR-6105, UVR-6110, UVR-6128, UVR-6200 (manufactured by Union Carbide Corp), Celoxide 2021, Celoxide 2021P, Celoxide 2081, Celoxide 2083, Celoxide 2085, Celoxide 2000, Celoxide 3000, Cyclomer A200, Cyclomer M100, Cyclomer M101, Epolead GT-301, Epolead GT-302, Epolead 401, Epolead 403, ETHB, Epolead HD300 (manufactured by Daicel Chemical Industry Co., Ltd.), and KRM-2110, KRM-2199 (manufactured by Asahi Denka Kogyo Co., Ltd.).

The above cyclohexene oxide compounds may be used as component (A) either individually or in combinations of two or more.

The proportion of component (A) in the photo-curable resin composition of the present invention is 30-80% by weight, preferably 35-75% by weight, and more preferably 40-70% by weight. If the proportion of component (A) is too low, the photocurability of the resulting resin composition is reduced, leading to a reduction in the molding effect. If the proportion of component (A) is too high, the toughness and dimensional accuracy of the resulting three-dimensional object produced from the resin composition are reduced.

<u>(B) Glycidyl Ether Compound</u>

The compound having a glycidyl ether structure (herein called "glycidyl ether compound") which is included in the photo-curable resin composition of the present invention as component (B) is a cationic polymerizable organic compound.

The following are examples of glycidyl ether compounds that can be used as component (B): bisphenol A diglycidyl ether, bisphenol F diglycidyl ether, bisphenol S diglycidyl ether, bisphenol AD diglycidylether, brominated bisphenol A diglycidyl ether, brominated bisphenol F diglycidyl ether, brominated bisphenol S diglycidyl ether, brominated bisphenol AD diglycidyl ether, hydrogenated bisphenol A diglycidyl ether, hydrogenated bisphenol F diglycidyl ether, hydrogenated bisphenol AD diglycidyl ether, epoxy novolac resin, 1,4-butanediol diglycidyl ether, 1,6-hexanediol diglycidyl ether, neopentyl glycol diglycidyl ether, glycerol triglycidyl ether, trimethylolpropane triglycidyl ether, polyethylene glycol diglycidyl ether, polypropylene glycol diglycidyl ethers; polyglycidyl ethers of polyether polyol obtained by adding one or more groups of alkylene oxide to aliphatic polyhydric alcohol such as ethylene glycol, propylene glycol, or glycerol; monoglycidyl ethers of aliphatic higher alcohol; or monoglycidyl ethers of phenol, cresol, butyl phenol, or polyether alcohol obtained by the addition of alkylene oxide to phenol, cresol, or butyl phenol.

Preferred examples of commercially available products of the a glycidyl ether compound which can be used as component (B) are Epicoat 801, Epicoat 828 (manufactured by Yuka Shell Epoxy Co., Ltd.), PY-306, 0163, DY-022 (manufactured by Ciba Geygy), KRM-2720, EP-4000, EP-4080, EP-4900, ED-505 (manufactured by Asahi Denka Kogyo Co., Ltd.), Epolight M-1230, Epolight EHDG-L, Epolight 40E, Epolight 100E, Epolight 200E, Epolight 400E, Epolight 70P, Epolight 200P, Epolight 1500NP, Epolight 1600, Epolight 80MF, Epolight 100MF, Epolight 4000, Epolight 3002, Epolight FR-1500 (manufactured by Kyoeisha Chemical Co., Ltd.), and Suntoto ST3000, YD-716, YH-300, PG-202, PG-207, YD-172, YDPN638 (manufactured by Toto Kasei Co., Ltd.)

The above glycidyl ether compounds may be used as component (B) either individually or in combinations of two or more.

The proportion of component (B) in the photo-curable resin composition of the present invention is 5-40% by weight, preferably 7-35% by weight, and more preferably 10-30% by weight. If the proportion of component (B) is too low, the three-dimensional object from the resulting resin composition tends to deform with time and its mechanical characteristics such as toughness decrease. If the proportion of component (B) is too high, the photocuring characteristic of the resulting resin composition decreases, leading to a reduction in molding effect.

<u>(C) Onium salt represented by Formula (1)</u>

The onium salt represented by the above formula (1) is employed as component C of the photo-curable resin composition of the present invention. The onium salt is a compound (cationic photo-initiator compound) capable of supplying a substance which initiates cationic polymerization of the above components (A) and (B) upon exposure to radiation from light.

Examples of aromatic groups with a valence of 1-4, which are represented by Aro in formula (1), are

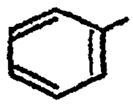, 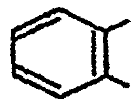, 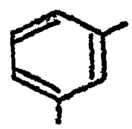, 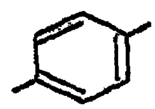, 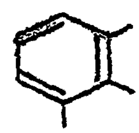,

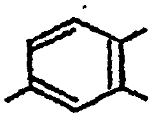, 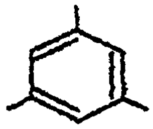, 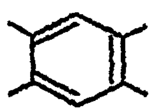, 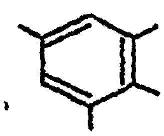, 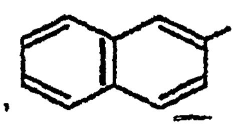,

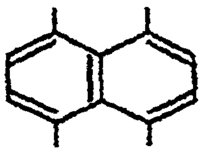, 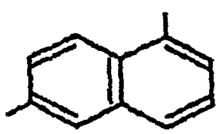, 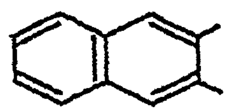,

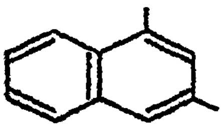, 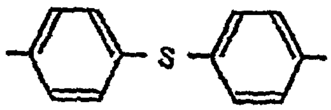, 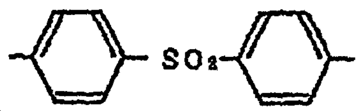,

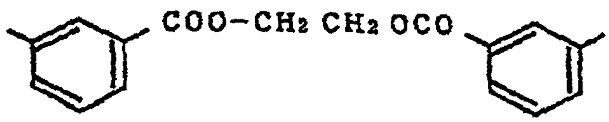

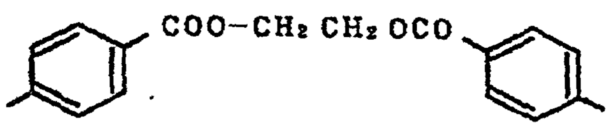

Among these, preferable groups are aromatic groups with a valence of 1 such as a phenyl group or naphthyl group and aromatic groups with a valence of 2 in which two aromatic groups are combined in the metha-position (positions 1 and 3), such as m-phenylene and m-naphthylene groups. The aromatic groups represented by Aro may include one or more of the following substitutional groups: alkyl groups having 1-4 carbon atoms such as a methyl group, ethyl group, propyl group, and butyl group; alkylcarbonyloxy groups containing an alkyl group having 1-4 carbon atoms; halogen atoms such as a fluorine atom, chlorine atom, bromine atom, and iodine atom; alkoxy groups having 1-4 carbon atoms; benzoyl groups; phenyl groups; phenylthio groups; alkylthio groups containing an alkyl group having 1-4 carbon atoms; or cyano groups.

In the above formula (2) denoting the bisphenylsulfonio groups represented by the symbol X in the above formula (1), $R^1$-$R^{10}$ independently represent a hydrogen atom, halogen atom, nitro group, alkoxy group, alkyl group, phenyl group which may be substituted with a substituent having 6-18 carbon atoms, phenoxy group, phenylcarbonyl group, alkylthio group, phenylthio group, benzyloxy group, aliphatic group having 1-25 carbon atoms and at least one hydroxyl group, or aliphatic group having 3-25 carbon atoms and containing a group represented by the formula $-OCH_2CH(R^{11})O-$, wherein R11 is a hydrogen atom or alkyl group.

Examples of suitable halogen atom constituting the substitutional groups $R^1$-$R^{10}$ are a fluorine atom, chlorine atom, bromine atom, or iodine atom. Among these, a fluorine atom is preferred.

Given as examples of the alkoxy groups constituting the substitutional groups $R^1$-$R^{10}$ are those having 1-25 carbon atoms such as a methoxy group, ethoxy group, propoxy group, butoxy group, or pentoxy group. Among these, alkoxy groups having 1-5 carbon atoms are preferred.

Examples of suitable alkyl groups constituting the substitutional groups $R^1$-$R^{10}$ are those having 1-25 carbon atoms such as a methyl group, ethyl group, propyl group, butyl group, or pentyl group. Among these, alkyl groups

having 1-5 carbon atoms are preferred.

Examples of suitable phenyl groups constituting the substitutional groups $R^1$-$R^{10}$ are those substituted with an alkyl group having 6-18 carbon atoms such as a nonyl group. Among these, those substituted in the metha-position are preferred.

Examples of suitable alkylthio groups constituting the substitutional groups $R^1$-$R^{10}$ are a methylthio group, ethylthio group, propylthio group, butylthio group, or pentylthio group.

Examples of suitable aliphatic groups having 1-25 carbon atoms and at least one hydroxyl group, which constitutes the substitutional group $R^1$-$R^{10}$, are linear or cyclic aliphatic groups represented by the general formula (4).

Formula (4):

$$-Y-R^{12}-(-OH)_h$$

wherein Y represents an oxygen atom or sulfur atom, $R^{12}$ is a polymethylene group, such as a methylene group, dimethylene group, trimethylene group, or tetramethylene group, which has 1-25 carbon atoms and which may include an alkyl group having 1-5 carbon atoms such as a methyl group or ethyl group, or a cycloalkylene group having 3-10 carbon atoms, and h denotes an integer from 1-3. As the groups represented by the formula (4), for example, those represented by the following formulas are given.

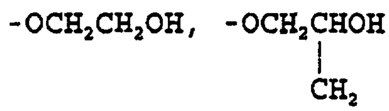

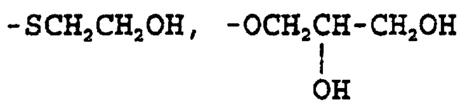

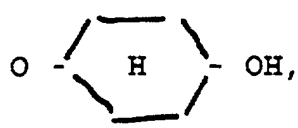
,
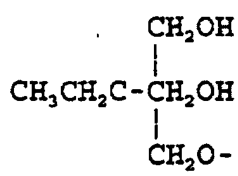

$-O-CH_2CH_2CH_2CH_2OH$

Examples of suitable aliphatic groups having 3-25 carbon atoms and containing the group represented by the formula, $-OCH_2CH(R^{11})O-$, which constitute the substitutional groups $R^1$-$R^{10}$ are those represented by the following general formula.

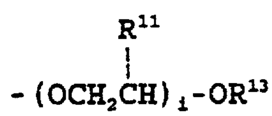

(wherein $R^{11}$ and $R^{13}$ independently represent a hydrogen atom or alkyl group and i denotes an integer from 2-12, preferably from 2-5). For example, groups such as $-(OCH_2CH_2)_2OH$, $-(OCH_2CH_2)_3OH$, or $-(OCH_2CH_2)_2OCH_3$, and the aliphatic groups represented by the following formulas,

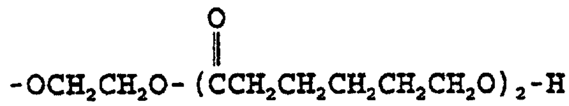

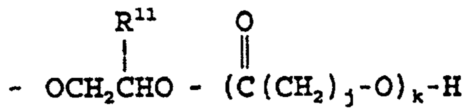

wherein $R^{11}$ represents a hydrogen atom or alkyl group, j denotes an integer from 1-10, and k denotes an integer of 1 or 2.

Given as examples of the alkyl group represented by $R^{11}$ are those having 1-5 carbon atoms such as a methyl group, ethyl group, propyl group, butyl group, or pentyl group.

Among these, preferred examples as the substitutional groups $R^1$-$R^{10}$ are a halogen atom, alkyl group, alkoxy group, aliphatic group having 1-25 carbon atoms and at least one hydroxyl group, and an aliphatic group having 3-25 carbon atoms and a group represented by the formula, $-OCH_2CH(R^{11})O-$. Preferred combinations of $R^1$-$R^{10}$ in the above formula (2) are as follows:

(1) A combination in which, among $R^1$-$R^{10}$, 6-9 groups are hydrogen and 1-4 groups are groups other than a hydrogen atom.
(2) A combination in which, in the above combination (1), among $R^1$-$R^5$, 3 or 4 groups are hydrogen and 1 or 2 groups are groups other than a hydrogen atom, and among $R^6$-$R^{10}$, 3-5 groups are hydrogen and 0-2 groups are groups other than a hydrogen atom.
(3) A combination in which, in the above combination (2), among $R^1$-$R^3$, any one group, preferably $R^1$ or $R^2$, is a group other than a hydrogen atom and the other groups are hydrogen.
(4) A combination in which, in the above combination (2), any one or two groups among $R^1$-$R^3$ and any one or two groups among $R^6$-$R^8$ are independently a halogen atom, alkyl group, or alkoxy group and the other groups are hydrogen.
(5) A combination in which, in the above combination (4), $R^3$ and $R^8$ are an alkyl or alkoxy group and other groups are hydrogen.
(6) A combination in which, in the above combination (4), $R^3$ and $R^8$ are a halogen atom and other groups are hydrogen.

In the above formula (1), a denotes an integer from 1-4, preferably 1 or 2, b denotes an integer of 0 or from 1-3, preferably 0, and n denotes an integer from 1-4, preferably 1 or 2.

Also, in the above formula (3) denoting the halides (negative ion) represented by the symbol Z in the formula (1), M represents a boron atom, phosphorus atom, arsenic atom, or antimony atom. Among these, a phosphorus atom or antimony atom is preferred. Also, in the formula (3), a fluorine atom is preferred among halogen atoms represented by the symbol Q, m denotes an integer from 3-6, preferably 5 or 6, and L denotes an integer of 0 or 1, preferably 0. Given as preferred examples of the halides (negative ion) are tetrafluoroborate ($BF_4^-$), hexafluorophosphate ($PF_6^-$), hexafluoroantimonate ($SbF_6^-$), hexafluoroarsenate ($AsF_6^-$), and hexachloroantimonate ($SbCl_6^-$). Among these, hexafluorophosphate and hexafluoroantimonate are more preferred.

Among the onium salts represented by the above formula (1), especially preferable examples as component (c) contained in the photo-curable resin composition of the present invention are sulfonium salts represented by the following formulas (compounds (c-i) to (c-ix)).

Compound (c-i)

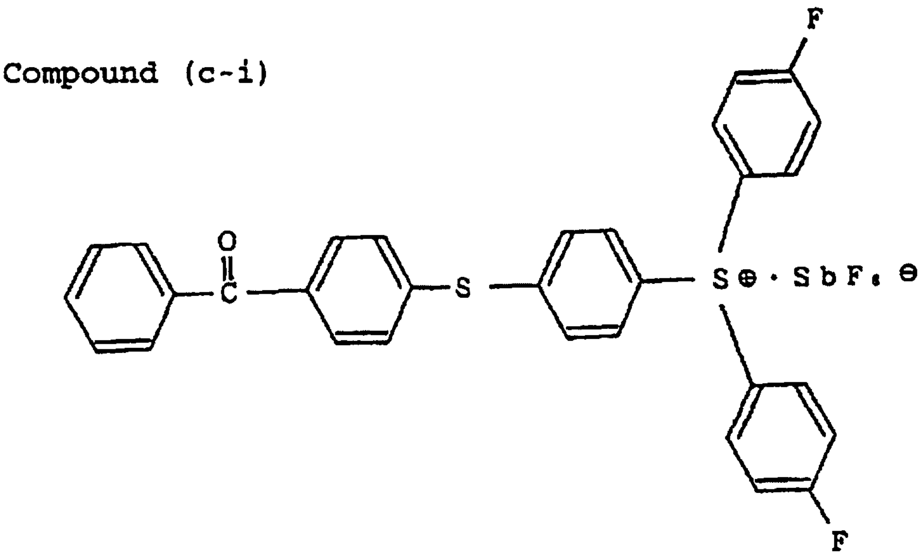

Compound (c-ii)

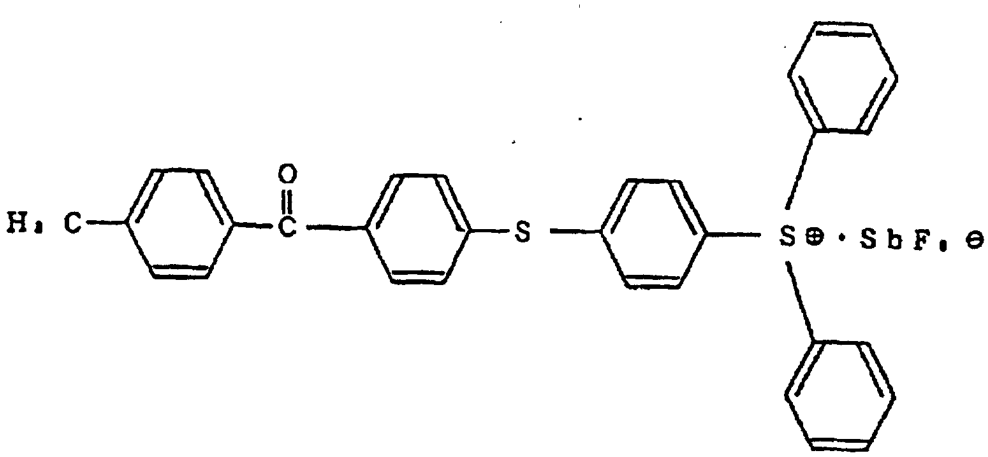

Compound (c-iii)

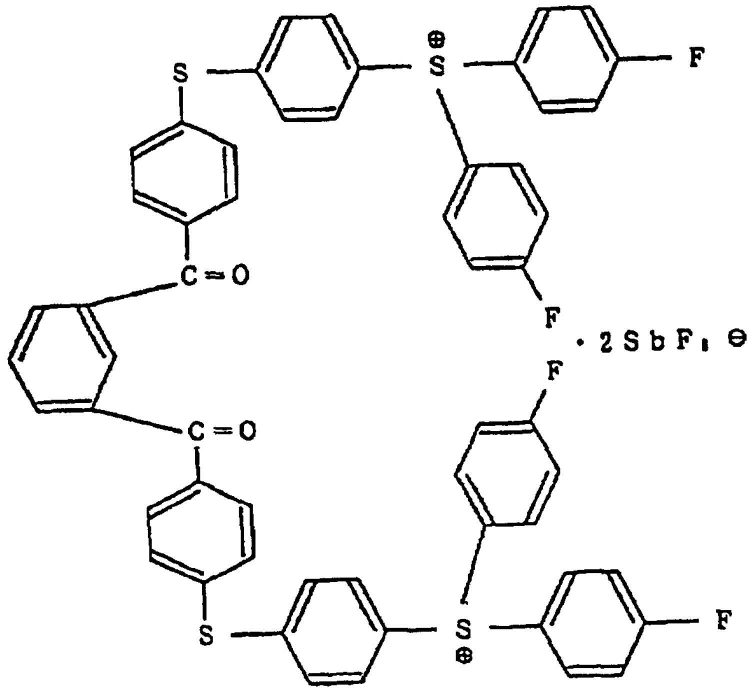

Compound (c-iv)

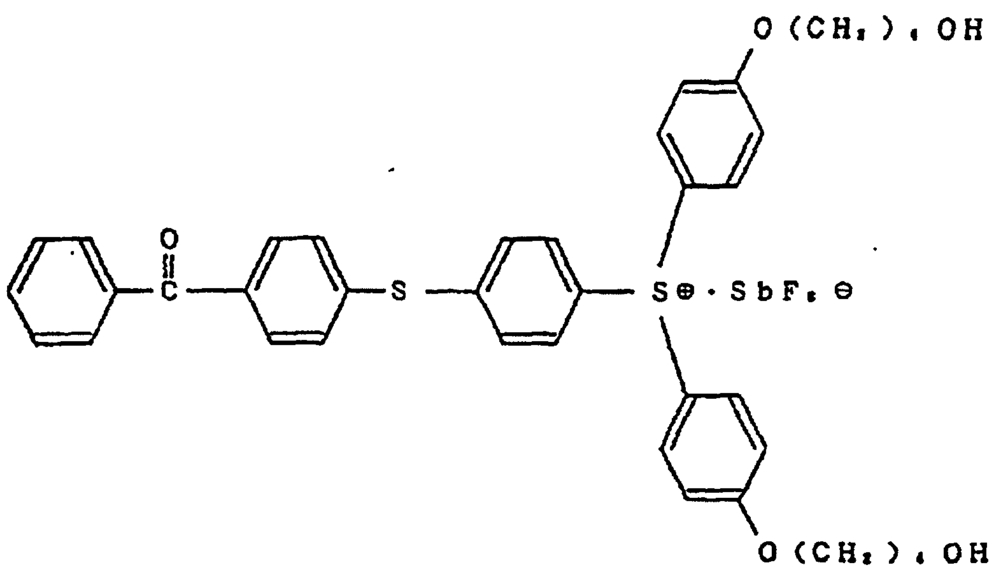

Compound (c-v)

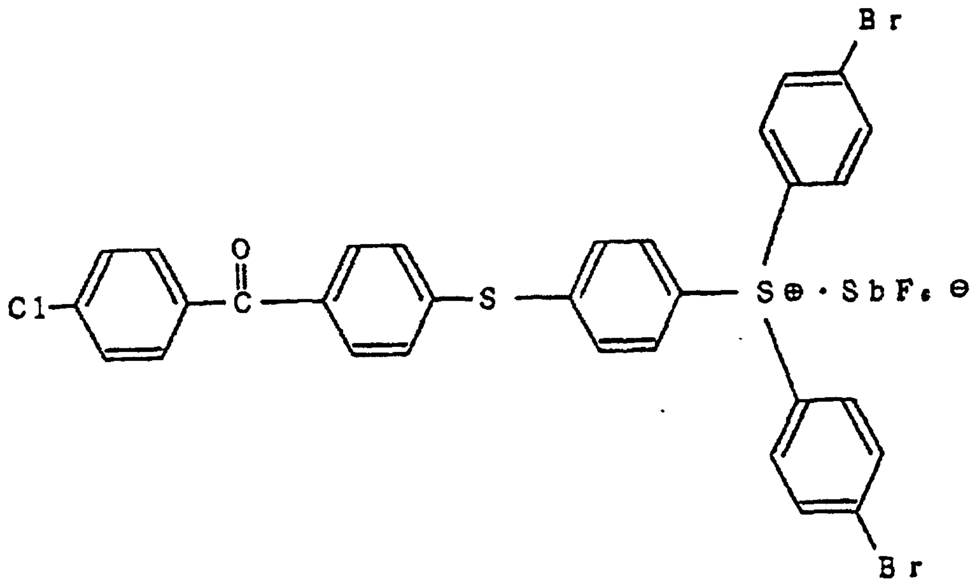

Compound (c-vi)

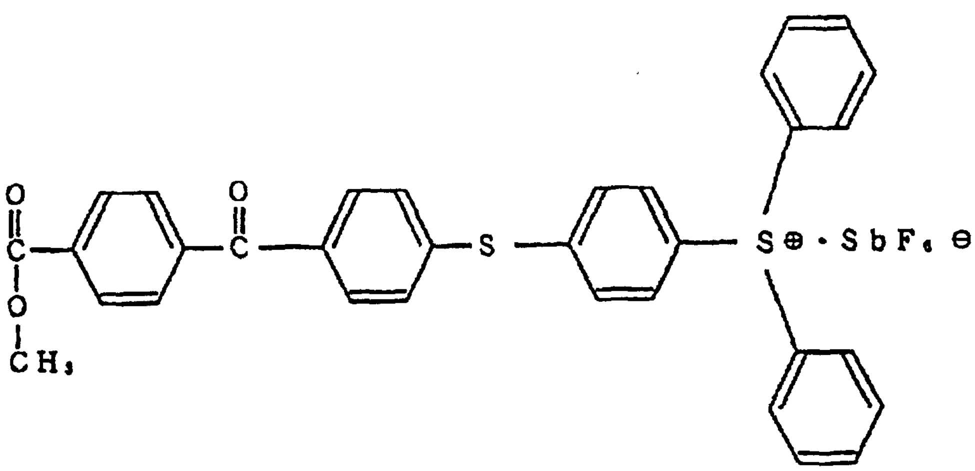

Compound (c-vii)

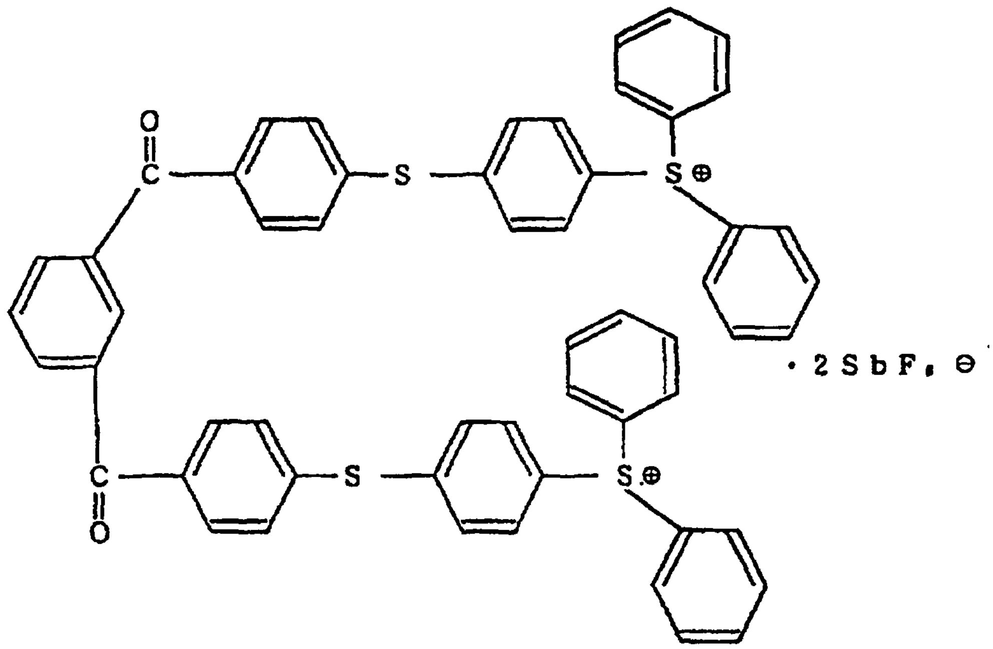

Compound (c-viii)

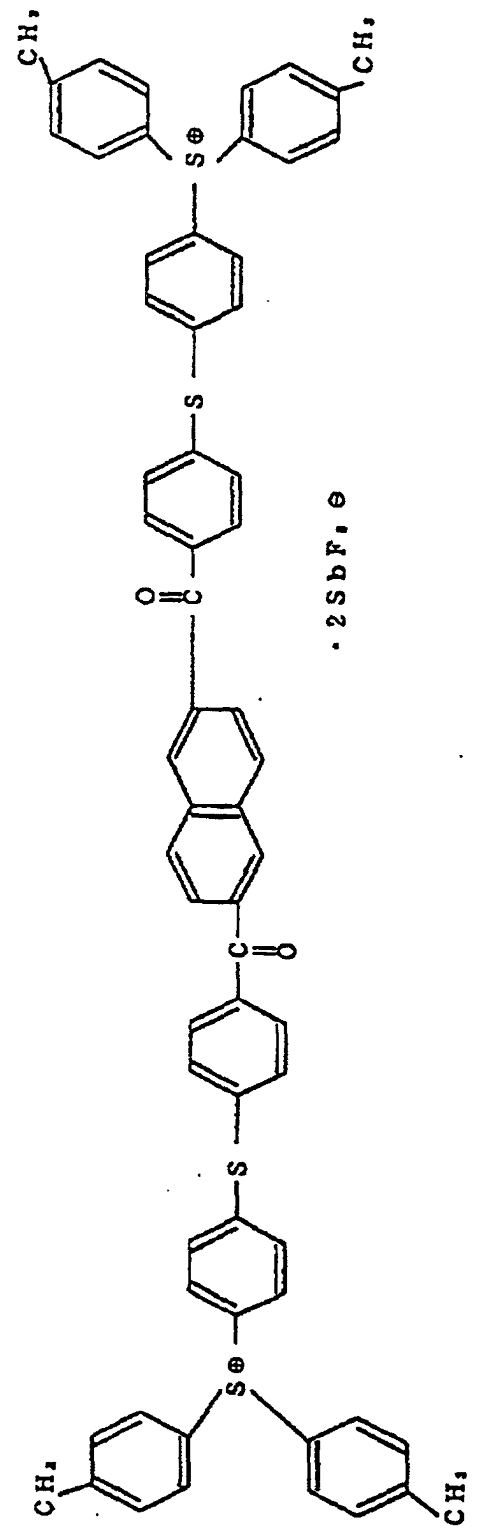

Compound (c-ix)

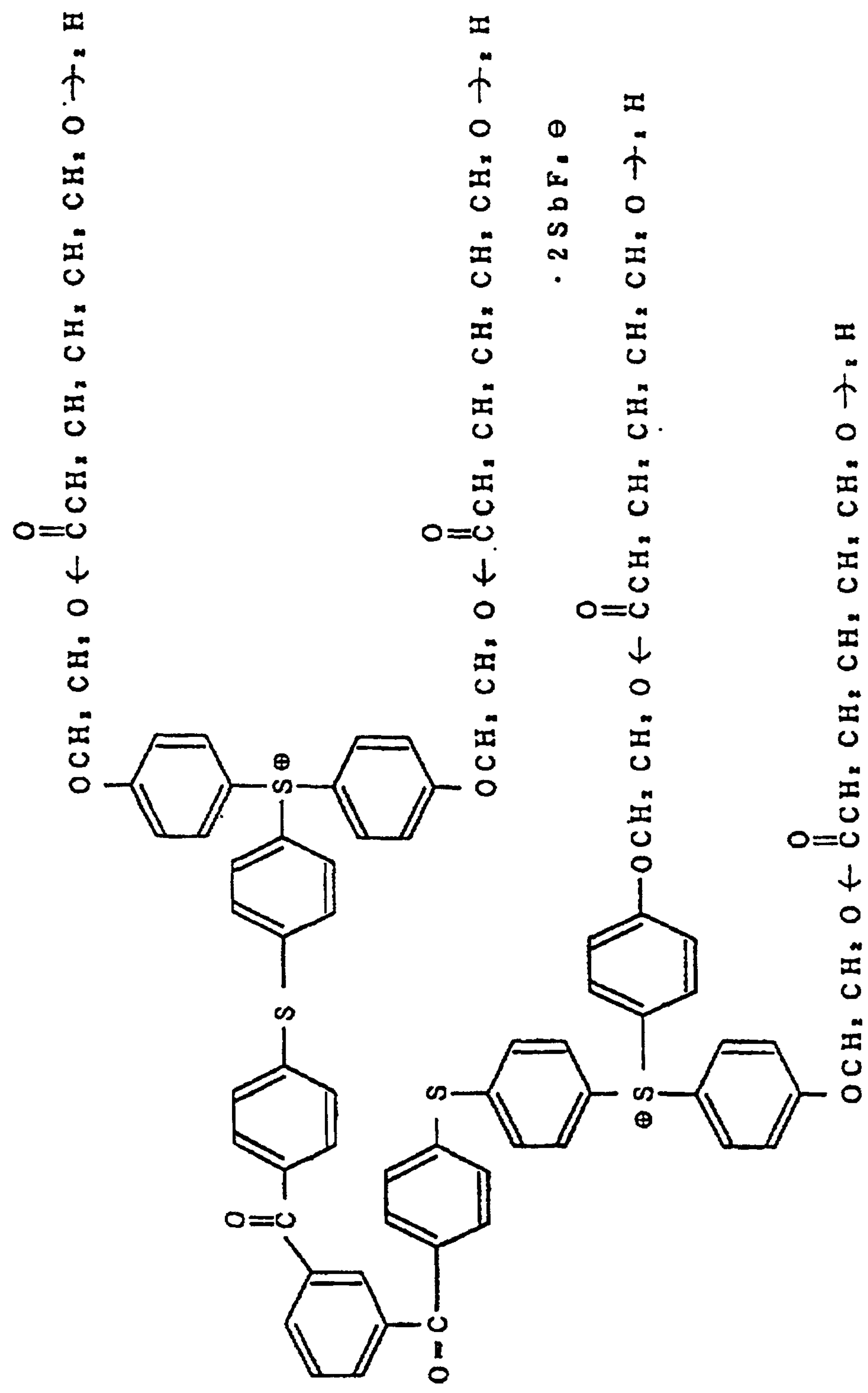

The onium salts (cationic photo-initiator) represented by the above formula (1) are used as component (C)

either individually or in combinations of two or more.

The proportion of component (C) in the photo-curable resin composition of the present invention is 0.1-10% by weight, preferably 0.2-5% by weight, and more preferably 0.3-3% by weight. If the proportion of component (C) is too low, the photocurability of the resulting resin composition is lowered so that no three-dimensional object having sufficient mechanical strength can be fabricated. On the other hand, if the proportion of component (C) is too high, an appropriate light transmission capability (curing depth) cannot be obtained when the resulting resin composition is used in the photo-fabrication process. Mechanical strength such as the toughness of the three-dimensional object prepared from this resin composition tends to be reduced.

(D) Ethylenically unsaturated monomer

Ethylenically unsaturated monomers, employed as component D, are compounds having ethylenically unsaturated groups (C=C). Given as typical examples of component (D) are monofunctional monomers having one ethylenically unsaturated bond in one molecule, and polyfunctional monomers having two or more ethylenically unsaturated bonds in one molecule.

Examples of the mono-functional monomer preferably used as component (D) are (meth)acrylamide, (meth) acryloyl morpholine, 7-amino-3,7-dimethyloctyl (meth)acrylate, isobutoxymethyl (meth)acrylamide, isobornyloxyethyl (meth)acrylate, isobornyl (meth)acrylate, 2-ethylhexyl (meth)acrylate, ethyldiethylene glycol (meth)acrylate, t-octyl (meth)acrylamide, diacetone (meth)acrylamide, dimethylaminoethyl (meth)acrylate, diethylaminoethyl (meth)acrylate, lauryl (meth)acrylate, dicyclopentadiene (meth)acrylate, dicyclopentenyloxyethyl (meth)acrylate, dicyclopentenyl (meth)acrylate, N,N-dimethyl (meth)acrylamide tetrachlorophenyl (meth)acrylate, 2-tetrachlorophenoxyethyl (meth) acrylate, tetrahydrofurfuryl (meth)acrylate, tetrabromophenyl (meth)acrylate, 2-tetrabromophenoxyethyl (meth)acrylate, 2-trichlorophenoxyethyl (meth)acrylate, tribromophenyl (meth)acrylate, 2-tribromophenoxyethyl (meth)acrylate, 2-hydroxyethyl (meth)acrylate, 2-hydroxypropyl (meth)acrylate, vinyl caprolactam, N-vinyl pyrrolidone, phenoxyethyl (meth)acrylate, butoxyethyl (meth)acrylate, pentachlorophenyl (meth)acrylate, pentabromophenyl (meth)acrylate, polyethylene glycol mono-(meth)acrylate, polypropylene glycol mono-(meth)acrylate, bornyl (meth)acrylate, methyltriethylene diglycol (meth)acrylate, and the compounds shown in the following general formulas (5) to (7).

Formula (5)

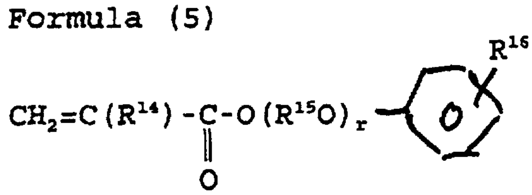

Formula (6)

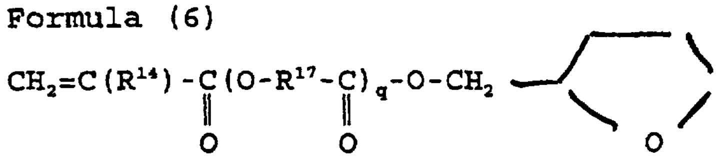

Formula (7)

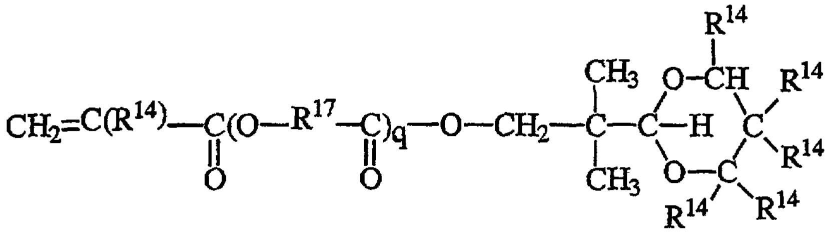

wherein $R^{14}$ independently represents a hydrogen atom or a methyl group, $R^{15}$ represents an alkylene group containing 2-6, preferably 2-4 carbon atoms, $R^{16}$ represents a hydrogen atom or an alkyl group containing 1-12, preferably 1-9 carbon atoms, $R^{17}$ represents an alkylene group containing 2-8, preferably 2-5 carbon atoms, r denotes an integer from 0-12, preferably from 1-8, and q denotes an integer from 1-8, preferably from 1-4.

Among these monofunctional monomers, isobornyl (meth)acrylate, lauryl (meth)acrylate, and phenoxyethyl (meth)acrylate are particularly preferable.

Examples of commercially available products of the monofunctional monomers are Aronix M-101, M-102, M-111, M-113, M-117, M-152, TO-1210 (manufactured by Toagosei Chemical Industry Co., Ltd.), KAYARAD TC-110S, R-564, R-128H (manufactured by Nippon Kayaku Co., Ltd.), and Viscoat 192, Viscoat 220, Viscoat 2311HP, Viscoat 2000, Viscoat 2100, Viscoat 2150, Viscoat 8F, Viscoat 17F (manufactured by Osaka Organic Chemical Industry Co., Ltd.)

Preferable examples of the polyfunctional monomers used as component (D) are ethylene glycol di(meth) acrylate, dicyclopentenyl di(meth)acrylate, triethylene glycol diacrylate, tetraethylene glycol di(meth)acrylate, tricyclodecanediyldimethylene di(meth)acrylate, tris(2-hydroxyethyl)isocyanurate di(meth)acrylate, tris(2-hydroxyethyl)isocyanurate tri(meth)acrylate, caprolactone modified tris(2-hydroxylethyl)isocyanurate tri(meth)acrylate, trimethylolpropane tri(meth)acrylate, ethylene oxide (hereinafter called [EO]) modified trimethylolpropane tri(meth)acrylate, propylene oxide (hereinafter called [PO]) modified trimethylolpropane tri(meth)acrylate, tripropylene glycol di(meth)acrylate, neopentyl glycol di(meth)acrylate, both terminal (meth)acryric acid adduct of bisphenol A diglycidyl ether, 1,4-butanediol di(meth)acrylate, 1,6-hexanediol di(meth)acrylate, pentaerythritol tri(meth)acrylate, pentaerythritol tetra(meth)acrylate, polyester di(meth)acrylate, polyethylene glycol di(meth)acrylate, dipentaerythritol hexa(meth)acrylate, dipentaerythritol penta(meth)acrylate, dipentaerythritol tetra(meth)acrylate, caprolactone modified dipentaerythritol hexa(meth)acrylate, caprolactone modified dipentaerythritol penta(meth)acrylate, ditrimethylolpropane tetra(meth)acrylate, EO modified bisphenol A di(meth)acrylate, PO modified bisphenol A di(meth)acrylate, EO modified hydrogenated bisphenol A di(meth)acrylate, PO modified hydrogenated bisphenol A di(meth)acrylate, EO modified bisphenol F di(meth)acrylate, and (meth)acrylate of phenol novolac polyglycidyl ether.

Commercially available products of these polyfunctional monomers are SA1002 (manufactured by Mitsubishi Chemical Corp.), Viscoat 195, Viscoat 230, Viscoat 260, Viscoat 215, Viscoat 310, Viscoat 214HP, Viscoat 295, Viscoat 300, Viscoat 360, Viscoat GPT, Viscoat 400, Viscoat 700, Viscoat 540, Viscoat 3000, Viscoat 3700 (manufactured by Osaka Organic Chemical Industry Co., Ltd.), KAYARAD R-526, HDDA, NPGDA, TPGDA, MANDA, R-551, R-712, R-604, R-684, PET-30, GPO-303, TMPTA, THE-330, DPHA, DPHA-2H, DPHA-2C, DPHA-2I, D-310, D-330, DPCA-20, DPCA-30, DPCA-60, DPCA-120, DN-0075, DN-2475, T-1420, T-2020, T-2040, TPA-320, TPA-330, RP-1040, RP-2040, R-011, R-300, R-205 (manufactured by Nippon Kayaku Co., Ltd.), Aronix M-210, M-220, M-233, M-240, M-215, M-305, M-309, M-310, M-315, M-325, M-400, M-6200, M-6400 (manufactured by Toagosei Co., Ltd.), Light acrylate BP-4EA, BP-4PA, BP-2EA, BP-2PA, DCP-A (manufactured by Kyoeisha Chemical Industry Co., Ltd.), New Frontier BPE-4, TEICA, BR-42M, GX-8345 (manufactured by Daiichi Kogyo Seiyaku Co., Ltd.), ASF-400 (manufactured by Nippon Steel Chemical Co., Ltd.), Ripoxy SP-1506, SP-1507, SP-1509, VR-77, SP-4010, SP-4060 (manufactured by Showa Highpolymer Co., Ltd.), and NK Ester A-BPE-4 (manufactured by Shin-Nakamura Chemical Industry Co., Ltd.).

It is preferable that the polyfunctional monomers having three or more ethylenically unsaturated bonds compose more than 60% by weight, of component (D) introduced into the photo-curable resin composition of the present invention. The proportion of component D comprising the polyfunctional monomer having three or more functional groups is more preferably more than 80% by weight. It is particularly preferable when component D is 100% polyfunctional monomer having three or more functional. If the proportion of the polyfunctional monomer having three or more functional groups is less than 60% by weight, the photocuring characteristic of the resulting resin composition is insufficient and the three-dimensional molded object tends to deform with time.

The polyfunctional monomer having three or more polyfunctional groups can be selected from the above-mentioned tri(meth)acrylate compounds, tetra(meth)acrylate compounds, penta(meth)acrylate compounds, and hexa (meth)acrylate compounds. Among these, trimethylol propane tri(meth)acrylate, EO modified trimethylolpropane tri (meth)acrylate, dipentaerythritol hexa(meth)acrylate, dipentaerythritol penta(meth)acrylate, and ditrimethylolpropane tetra(meth)acrylate are particularly preferable.

The above monofunctional monomers and polyfunctional monomers may be used as component (D) either individually or in combinations of two or more.

The proportion of component (D) in the photo-curable resin composition of the present invention is generally 5-30% by weight, preferably 7-25% by weight, and more preferably 10-20% by weight. If the proportion of component (D) is too low, the photocuring characteristic of the resin composition is insufficient. A three-dimensional object with sufficient mechanical strength cannot be fabricated from such resin composition. On the other hand, if the proportion of component (D) is too high, the resulting resin composition shrinks easily during photo-curing and the mechanical strength such as toughness of the three-dimensional object tends to be reduced.

<u>(E) Radical photo-initiator</u>

Radical photo-initiators employed as component E of the resin composition of the present invention are compounds which decompose and generate radicals by receiving radiation such as light and initiates a radical reaction of component (D) by the action of the radicals.

Given as specific examples of the radical photo-initiators which can be used as component (E) are acetophenone, acetophenone benzyl ketal, anthraquinone, 1-(4-isopropylphenyl)-2-hydroxy-2-methylpropan-1-one, carbazole, xanthone, 4-chlorobenzophenone, 4,4' -diaminobenzophenone, 1,1-dimethoxydeoxybenzoin, 3,3'-dimethyl-4-methoxybenzophenone, thioxanethone compounds, 2-methyl-1-[4-(methylthio) phenyl] -2-morpholino-propan-2-on, 2-benzyl-2-dimethylamino-1-(4-morpholinophenyl)-butan-1-one, triphenylamine, 2,4,6-trimethylbenzoyl diphenylphosphine oxide, bis(2,6-dimethoxybenzoyl)-2,4,4-tri-methylpentylphosphine oxide, benzyl dimethyl ketal, 1-hydroxycyclohexylphenyl ketone, 2-hydroxy-2-methyl-1-phenylpropan-1-one, fluorenone, fluorene, benzaldehyde, benzoin ethyl ether, benzoin propyl ether, benzophenone, Michler's ketone, 3-methylacetophenone, 3,3',4,4'-tetra (t-butyl peroxycarbonyl) benzophenone (BTTB), and combined compositions of BTTB and xanthene, thioxanthene, cumarin, ketocumarin or other coloring matter photosensitizer. Among these, benzyl methyl ketal, 1-hydroxycyclohexylphenyl ketone, 2,4,6-trimethylbenzoyl diphenylphosphine oxide, 2-benzyl-2-dimethylamino-1-(4-morpholinophenyl)-butan-1-one, are particularly preferred.

These radical photo-initiators may be used as component(E) either individually or in combinations of two or more.

The proportion of component (E) in the photo-curable resin composition of the present invention is usually 0.01-10% by weight and preferably 0.1-8% by weight. If the proportion of component (E) is too low, the rate (curing rate) of the radical polymerization is so reduced that fabrication time may be extended and the resolution may tend to be lower. On the other hand, if the proportion of component (E) is too high, the excess polymerization initiator sometimes has an adverse effect on the curing characteristics of the resin composition and the specification, heat resistance, and handling of the three-dimensional object obtained from the resin composition.

<u>(F) Polyol</u>

The polyol (herein referred to as "component (F)" having three or more hydroxyl groups in one molecule is an essential component for developing the photo-curability of the resin composition and the shape stability (resistance to deformation with time) and the stability in properties (resistance to change in mechanical characteristics with time) of the three-dimensional object obtained from the resin composition. The polyol used as component (F) has three or more, preferably 3-6 hydroxyl groups in one molecule. If polyols having less than three hydroxyl groups (diol) are used, the aim of developing the photo-curing characteristic can not be achieved and a three-dimensional object with sufficient mechanical strength can not be produced. On the other hand, if polyols having 6 or more hydroxyl groups are used, the extensibility and toughness of the three-dimensional object obtained from the resin composition tends to be lower.

Given as specific examples of component (F) are polyether polyols prepared by modifying polyhydric alcohol of more than a valence of 3 for example trimethylolpropane, glycerol, pentaerythritol, sorbitol, sucrose, quodrol, or the like by a cyclic ether compound such as ethylene oxide (EO), propylene oxide (PO), butylene oxide, tetrahydrofuran; caprolactone polyols prepared by modifying caprolactone; and polyether polyols prepared by modifying by a polyester consisting of a dibasic acid and diol. Specific examples of such polyols are EO modified trimethylolpropane, PO modified trimethylolpropane, tetrahydrofuran modified trimethylolpropane, caprolactone modified trimethylolpropane, EO modified glycerol, PO modified glycerol, tetrahydrofuran modified glycerol, caprolactone modified glycerol, EO modified pentaerythritol, PO modified pentaerythritol, tetrahydrofuran modified pentaerythritol, caprolactone modified pentaerythritol, EO modified sorbitol, PO modified sorbitol, caprolactone modified sorbitol, EO modified sucrose, PO modified sucrose, and EO modified quodor. Among these, EO modified trimethylolpropane, PO modified trimethylolpropane, caprolactone modified trimethylolpropane, PO modified glycerol, caprolactone modified glycerol, and PO modified sorbitol are desirable.

The preferable molecular weight of the polyol used as component (F) is 100 to 2,000, and more preferably 160-1,000. If polyols having too small a molecular weight are used as component (F), it is difficult to prepare a three-dimensional object with stable shape and properties depending on the resulting resin composition. On the other hand, If polyols having too large molecular weight are used as component (F), the viscosity of the resulting resin composition becomes too large, resulting in lowering of the mechanical strength of the three-dimensional object obtained by the photo-fabrication process.

Given as specific examples of commercially available products of the polyols which can be used as component (F) are Sunnix TP-400, Sunnix GP-600, Sunnix GP-1000, Sunnix SP-750, Sunnix GP-250, Sunnix GP-400, Sunnix GP-600 (manufactured by Sanyo Chemical Co., Ltd.), TMP-3 Glycol, PNT-4 Glycol, EDA-P-4, EDA-P-8 (manufactured by Nippon Nyukazai Co., Ltd.), G-300, G-400, G-700, T-400, EDP-450, SP-600, SC-800 (manufactured by Asahi Denka Kogyo Co., Ltd.), TONE 0301, TONE 0305, TONE 0310 (manufactured by Union Carbide Corp.), and PLACCEL 303, PLACCEL 305, PLACCEL 308 (manufactured by Daicel Chemical Industry, Ltd.).

The above-mentioned polyols can be used as component (F) either individually or in combinations of two or more.

The proportion of component (F) in the photo-curable resin composition of the present invention is usually 5-30% by weight, preferably 6-25% by weight, and more preferably 7-20% by weight. If the proportion of component (F) is too low, the aim of developing the photocuring characteristic can not be achieved and there are cases where a three-dimensional object with sufficient stability in shape and properties can not be produced depending on the resulting resin composition. Also, the toughness of the three-dimensional object tends to be reduced. On the other hand, if the proportion of component (F) is too high, the mechanical strength of the three-dimensional object obtained in the photo-fabrication process is reduced and there is a tendency for the three-dimensional object to be softened by the influence of water or humidity.

## Optional components

In addition to the above-mentioned components (A) to (F), various other components may be incorporated into the photo-curable resin composition of the present invention to the extent that the curability of this composition is not adversely affected. Such optional components include cationic polymerizable organic compounds other than components (A) and (B).

Typical examples of such cationic polymerizable organic compounds are epoxy compounds, oxetane compounds, oxalan compounds, cyclic acetal compounds, cyclic lactone compounds, thiirane compounds, thietane compounds, vinylether compounds, spiro-ortho ester compounds which are reaction products of an epoxy compound and lactone, ethylenically unsaturated compounds, cyclic ether compounds, cyclic thioether compounds, vinyl compounds, and their derivatives.

Typical examples of the epoxy compounds usable as the optional component are diglycidyl esters of aliphatic long chain dibasic acid and glycidyl esters of higher fatty acid.

Typical examples of the oxetane compounds usable as the optional component are trimethylene oxide, 3,3-dimethyloxetane, 3,3-dichloromethyloxetane, 3-ethyl-3-phenoxymethyloxetane, and bis(3-ethyl-3-methyloxy)butane.

Typical examples of the oxalan compounds usable as the optional component are tetrahydrofuran and 2,3-dimethyltetrahydrofuran.

Typical examples of the cyclic acetal compounds usable as the optional component are trioxane, 1,3-dioxalan, and 1,3,6-trioxane cyclooctane.

Typical examples of the cyclic lactone compounds usable as the optional component are β-propiolactone and ε-caprolactone.

Typical examples of the thiirane compounds usable as the optional component are ethylene sulfide, 1,2-propylene sulfide, and thioepichlorohydrin.

Typical examples of the thietane compounds usable as the optional component are 3,3-dimethylthietane.

Typical examples of the vinylether compounds usable as the optional component are ethylene glycol divinyl ether, triethylene glycol divinyl ether, and trimethylolpropane trivinyl ether.

Typical examples of the ethylenically unsaturated compounds usable as the optional component are vinyl cyclohexane, isobutylene, and polybutadiene.

Optional components other than the above cationic polymerizable organic compounds include photosensitizers (polymerization promoters) of amine compounds for example triethanolamine, methyl diethanolamine, triethylamine, diethylamine; photosensitizers including thioxantone or its derivatives, anthraquinone or its derivatives, anthracene or its derivatives, perillene and its derivatives, benzophenone, benzoin isopropylether, and reaction diluents such as vinyl ethers, vinyl sulfides, vinyl urethanes, urethane acrylates or vinyl ureas.

Also, various additives may be incorporated in the photo-curable resin composition of the present invention. Such additives include polymers or oligomers, such as epoxy resin, polyamide, polyamideimide, polyurethane, polybutadiene, polychloroprene, polyether, polyester, styrene-butadiene-styrene block copolymer, petroleum resin, xylene resin, ketone resin, cellulose resin, fluorine oligomer, silicon oligomer, and polysulfide oligomer; polymerization inhibitors for example phenothiazine or 2,6-di-t-butyl-4-methyl phenol, polymerization initiation adjuvants, antioxidants, leveling agents, wettability improvers, surfactants, plasticizers, UV absorbers, silane coupling agents, inorganic fillers, resin particles and pigments, dyes.

The photo-curable resin composition of the present invention can be manufactured by homogeneously blending the above-mentioned components (A) to (F), the optional components, and the various additives. It is desirable for the photo-curable resin composition of the present invention to possess a viscosity (25°C) in the range of 50-1,000 mPa.sec. (50-1,000 cps), preferably 70-500 mPa.sec. (70-500 cps).

Typically compositions of the present invention will have a camber value of less than 0.25, preferably less than 0.20, more preferable less than 0.15, after being exposed to 50% humidity for 30 days at 23°C.

Photo-fabrication process

The photo-curable resin composition of the present invention prepared in the manner discussed herein is suitable as a (liquid) photo-curable material used in photo-fabrication processes. Specifically, a three-dimensional object with a desired shape can be obtained by using the photo-fabrication process, including selectively radiating visible light, ultraviolet light, or infrared light on the photo-curable resin composition of the present invention, and providing the energy required to cure the resin composition.

Various means may be used to selectively irradiate the photo-curable resin composition with light with no specific limitations. Such light irradiation means include, for example, a means for irradiating the composition with a scanning laser beam or other scanning light and the like converged by a lens, mirror, or the like, while scanning, a means irradiating the composition with non-convergent light through a mask provided with a fixed pattern through which light is transmitted, and a means for irradiating the composition with light via a number of optical fibers bundled in a light conductive member corresponding to a fixed pattern. In the means using a mask, a mask electro-optically produces a mask image consisting of a light transmitting area and non-light-transmitting area according to a prescribed pattern by the same theory as that of the liquid crystal display apparatus. A means using a scanning laser beam with a small spot size is preferred for selectively irradiating the resin composition with light, when a resulting three-dimensional object possesses minute parts or when high dimensional accuracy is required to form the three-dimensional object.

Preferably, an Argon-ion laser is used in the photofabrication process to cure the resin composition of the present invention. Unexpectedly, the resin composition of the invention does not have to comprise a sensitiser to achieve very good cure speed.

In the above means, the irradiated surface (for example, the plane scanned by light) of the resin composition placed in a vessel is either the liquid level of the resin composition or the surface at which the liquid contacts the wall of a transparent vessel. When the irradiated surface is the liquid level or the contact surface of the wall of the vessel, the light can be shone directly out of the vessel or through the vessel.

In the above photo-fabrication process, a desired solid shape can be made by curing fixed parts of the resin composition and then moving the light spot from the cured parts to the uncured parts continuously or gradually to laminate the cured parts. There are various methods for moving the light spot, for example, a method for moving any of the light source, the vessel for the resin composition, or the cured parts of the resin composition. Also there is a method in which fresh resin composition is supplied to the cured resin composition in the vessel.

Illustrating a typical photo-fabrication process, the surface of a support stage capable of being optionally elevated in the vessel is lowered a suitable distance from the liquid surface to form a thin layer (1) of the resin composition. The thin layer (1) is selectively irradiated with light to form a solid cured resin layer (1'). The resin composition is supplied over this thin layer (1') to form a second thin layer (2), and this thin layer (2) is selectively irradiated with light to laminate a new solid cured resin layer (2') on the thin layer (1'). This step is repeated for a prescribed number of times, with or without changing the pattern subjected to light irradiation, to produce a three-dimensional object consisting of a multiple number of cured resin layers (n') which are integrally laminated.

The three-dimensional object fabricated in this manner is discharged from the vessel and processed to remove the unreacted photo-curable resin composition remaining on the surface, and washed by a solvent, as required. Given as examples of solvents are an organic solvent which is represented by an alcohol, such as isopropyl alcohol or ethyl alcohol, an organic solvent such as acetone, ethyl acetate, methylethyl ketone, an aliphatic organic solvent such as a terpene, or a low viscosity liquid thermosetting resin or photo-curable resin.

When forming a three-dimensional object with a smooth surface, it is desirable that the cured product be washed using the thermosetting resin or photo-curable resin. In this case, it is necessary to post-cure the product by heat emission or light irradiation depending on the type of solvent used in the washing stage. This post-curing treatment is effective not only for curing the resin remaining uncured on the surface of the laminated body, but also for curing the resin composition which remains uncured inside the laminated body. Thus, the post-curing treatment is also effective in the case where the fabricated three-dimensional object is washed with an organic solvent.

The three-dimensional object obtained in this manner has high mechanical strength, high dimensional accuracy, and excellent heat resistance. Also, the three-dimensional object exhibits high stability in maintaining a fixed shape and lasting stable properties. Therefore, the three-dimensional object prepared from the resin composition is preferably used for trial products of mechanical parts.

It is desirable to cover the surface of the three-dimensional object by a heat-curable or photo-curable hard coating agent to improve the strength and heat resistance of the surface. As such hard coating agent, an organic coating agent for example acryl resin, epoxy resin, silicon resin, or an inorganic coating agent can be used. These hard coating agents may be used individually or in combinations of two or more.

## EXAMPLES

The present invention will be explained in more detail by way of examples, which are not intended to be limiting of the present invention.

### Example 1

According to the formulation shown in Table 1, 48 parts by weight of 3,4-epoxycyclohexylmethyl-3',4'-epoxycyclohexane carboxylate (UVR-6110, manufactured by Union Carbide), 20 parts by weight of butanedioldiglycidyl ether (Araldite DY-022, manufactured by Ciba Geigy), 1 part by weight of the above component (c-i) prepared using the conventionally known method, 14 parts by weight of trimethylolpropane triacrylate (Viscoat 295, manufactured by Osaka Organic Chemical Ind. Co., Ltd.), 1 part by weight of 1-hydroxycyclohexylphenylketone (Irgacure 184, manufactured by Ciba Geigy), and 14 parts by weight of caprolactone modified triol (TONE-0301, manufactured by Union Carbide) were placed in a vessel equipped with a stirrer and the mixture was reacted with stirring at 60°C for one hour to prepare a transparent liquid composition (the resin composition of the present invention). The viscosity of the resulting liquid composition was measured at 25°C by means of a B type viscometer. The viscosity of the composition was 130 mPa.sec. (130 cps).

### Examples 2-4

Transparent liquid compositions (the photo-curable resin compositions of the present invention) were prepared in the same manner as in Example 1 according to the formulations shown in Table 1, except that different components were used. In these Examples, compounds (c-ii),(c-iii), and (c-iv) prepared using the conventionally known method were substituted for component (C).

### Comparative Examples 1-3

Transparent liquid compositions (comparative photo-curable resin compositions) were prepared in the same manner as in Example 1 according to the formulations shown in Table 1, except that the different components were used.

Table 1

| | | Example | | | | Comparative Example | | |
|---|---|---|---|---|---|---|---|---|
| | | 1 | 2 | 3 | 4 | 1 | 2 | 3 |
| 3,4-Epoxycyclohexylmethyl-3',4'-epoxycyclohexane carboxylate *1 | (A) | 48 | 48 | 48 | 48 | 48 | 48 | 48 |
| Butanedioldiglycidyl ether *2 | (B) | 20 | 20 | 20 | 20 | 20 | 20 | 20 |
| Component (c-i) | (C) | 1 | - | - | - | - | - | - |
| Component (c-ii) | (C) | - | 1 | - | - | - | - | - |
| Component (c-iii) | (C) | - | - | 1 | - | - | - | - |
| Component (c-iv) | (C) | - | - | - | 1 | - | - | - |
| Trimethylolpropane triacrylate *3 | (D) | 14 | 14 | 14 | 14 | 14 | 14 | 14 |
| 1-Hydroxycyclohexylphenylketone *4 | (E) | 1 | 1 | 1 | 1 | 1 | 1 | 1 |
| Caprolactone modified triol *5 | (F) | 14 | 14 | 14 | 14 | 14 | 14 | 14 |
| Photo-acid generator *6 | | - | - | - | - | 1 | 3 | 1 |
| Diethylthioxanthone *7 | | - | - | - | - | - | - | 0.5 |

*1) UVR-6110, manufactured by Union Carbide Corporation
*2) Araldite DY-022, manufactured by Ciba Geigy
*3) Viscoat 295, manufactured by Osaka Organic Industry Co., Ltd.
*4) Irgacure 184, manufactured by Ciba Geigy
*5) TONE-0301, manufactured by Union Carbide Corporation
*6) Bis[4-(diphenylsulfonio)phenyl]sulfide bishexafuluoro antimonate
*7) DETX-S, manufactured by Nippon Kayaku Co., Ltd.

Evaluation of photocurable resin composition

The photo-curable compositions prepared in the Examples 1-4 and the Comparative Examples 1-3 were evaluated by measuring the shape stability with time of the resulting cured products according to the following method.

(1) Preparation of test specimens

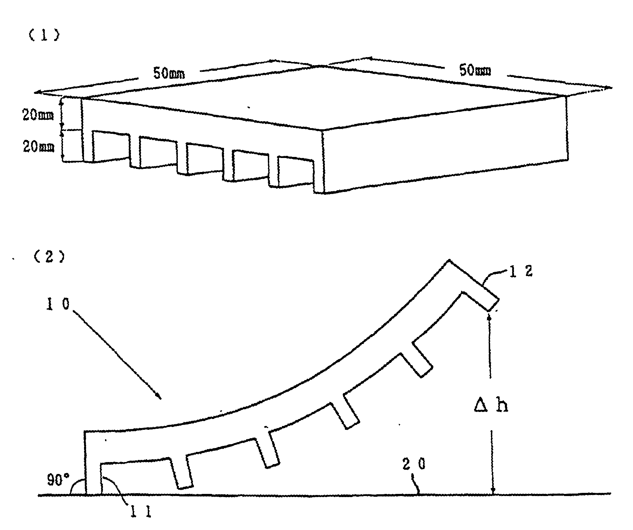

Using an photo-fabrication apparatus (Solid Creator JSC-2000, manufactured by Sony Corporation) equipped with a light source for applying Ar ion laser beam (wave length of 351 nm and 365 nm), a photo-curable resin composition was selectively irradiated by the laser beam under the conditions of a laser power of 100 mW measured on the irradiated surface (liquid level) and a scanning speed of 200-500 mm/s to form a cured resin film with a thickness of 0.2 mm. This fabrication procedure was repeated many times to form a model for measurement (hereinafter called [camber model]) as shown in Fig. 1 (1). The conditions of the scanning speed and scanning intervals of the laser beam were selected so that the resin composition could be cured to produce a three-dimensional object having sufficient mechanical strength.

The camber model was then discharged from the photo-fabrication apparatus, after which the residual resin composition adhering to the outer surface of the camber model was released, and the excess resin composition was removed using a terpene-type solvent.

The time (fabrication time) required for forming the camber model of each resin composition in the preparation of test specimens is shown in Table 2. The fabrication time depends on the transmitting capability (intrusive depth of laser beam) and light-sensitivity of the resin composition.

(2) Measurement

As shown in Fig.1 (2), measurements were made by securing the bottom of a foot part 11 of a camber model 10 to a plane 20 and measuring the distance (lift length Δh mm) between the plane 20 and the bottom of a foot part 12 to determine the primary camber rate.

After the camber model 10 was allowed to stand in a thermo-hygrostat at 23°C under a humidity of 50% for 30 days, the camber rate was measured in the same manner as in the above procedure.

Table 2

| | | Example | | | | Comparative Example | | |
|---|---|---|---|---|---|---|---|---|
| | | 1 | 2 | 3 | 4 | 1 | 2 | 3 |
| Fabrication time (min) | | 80 | 90 | 95 | 90 | 140 | 130 | 110 |
| Camber rate (mm) | Initial value | 0.00 | 0.00 | 0.00 | 0.00 | 0.00 | 0.10 | 0.00 |
| | After 30 days | 0.05 | 0.05 | 0.10 | 0.10 | 0.28 | 0.55 | 0.32 |

As is clear from Table 2, all cured products from the photo-curable resin compositions of the present invention prepared in the Examples 1-4 could be produced in a short fabrication time and had an excellent photocurability. Also, the cured product from the resin composition had a minimal deformation rate (camber rate) caused by shrinkage during curing and had excellent shape stability with time.

In contrast, the cured products formed from the composition prepared in the Comparative Examples 1 and 2, using bis [4- (diphenylsulfonio)phenyl] sulfide bishexafluoroantimonate instead of component (C), were produced in a long fabrication time and exhibited decreased photocurability. Also, the shape stability of the resulting cured products from the comparative resin compositions was degraded.

In addition, the resin composition prepared in the Comparative Example 3, using a photosensitizer (diethylthioxanthone), could be subjected to reduced fabrication time to some extent. However, the shape stability of the cured product was still low.

The photo-curable resin composition of the present invention can efficiently produce cured products (three-dimensional objects) possessing excellent primary mechanical strength in a short time by photo-fabrication processes due to the excellent photocurability.

The cured product produced from the photo-curable resin composition showed little change in mechanical properties, deformation rate with time, exhibited high mechanical strength, dimensional accuracy, and excellent heat resistance. The cured product can therefore be suitably used as a three-dimensional object, for example, as trial products for mechanical parts.

In addition, the photo-fabrication process using the photo-curable resin composition of the present invention can provide a three-dimensional object possessing excellent primary characteristics and high durability.

BRIEF DESCRIPTION OF THE DRAWINGS

Figure 1 is a diagram showing the configuration of the model for the measurement of deformation rate with time and explaining the measuring method.

## Claims

**1.** A photo-curable resin composition comprising,

(A) a compound having a cyclohexene oxide structure,
(B) a compound having a glycidyl ether structure,
(C) an onium salt represented by the following formula (1),
(D) an ethylenically unsaturated monomer,
(E) a radical photo-initiator, and
(F) a polyol having three or more hydroxyl groups in one molecule;

Formula (1):

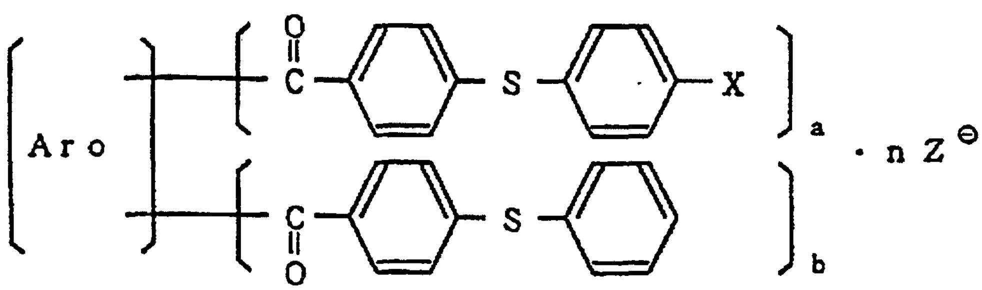

wherein Aro represents an aromatic group with a valence from 1-4, X represents a bisphenylsulfonio group which may contain a substitutional group represented by the following formula (2), and Z represents a halide represented by the following formula (3), a is an integer from 1-4, b is 0 or an integer from 1-3, the sum of a and b is an integer from 1-4, and n is an integer from 1-4;

Formula (2):

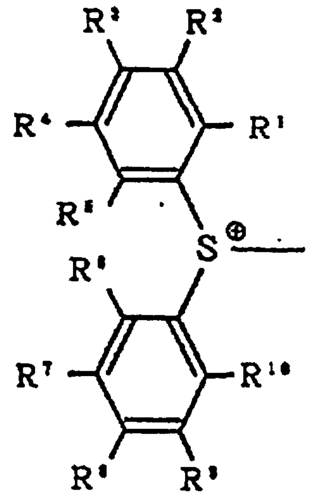

wherein $R^1$-$R^{10}$ respectively represent a hydrogen atom, halogen atom, nitro group, alkoxy group, alkyl group, phenyl group which may be substituted by a substitutional group having 6-18 carbon atoms, phenoxy group, phenylcarbonyl group, alkylthio group, phenylthio group, benzyloxy group, aliphatic group having 1-25 carbon atoms and at least one hydroxyl group, or aliphatic group having 3-25 carbon atoms and a group represented by the formula $-OCH_2CH(R^{11})O-$ ($R^{11}$ represents a hydrogen atom or alkyl group);

Formula(3):

$$MQ_m\text{-}(\text{-}OH)_L$$

wherein M is a boron atom, phosphorus atom, arsenic atom, or antimony atom, and Q is a halogen atom, m is an integer from 3-6, L is 0 or 1, and the sum of m+L is an integer from 4-6.

**2.** The photo-curable resin composition of claim 1, wherein the onium salt is selected from the group consisting of compounds c-i, c-ii, c-iii, c-iv, c-v, c-vi, c-vii, c-viii and c-ix, defined below:

Compound (c-i)

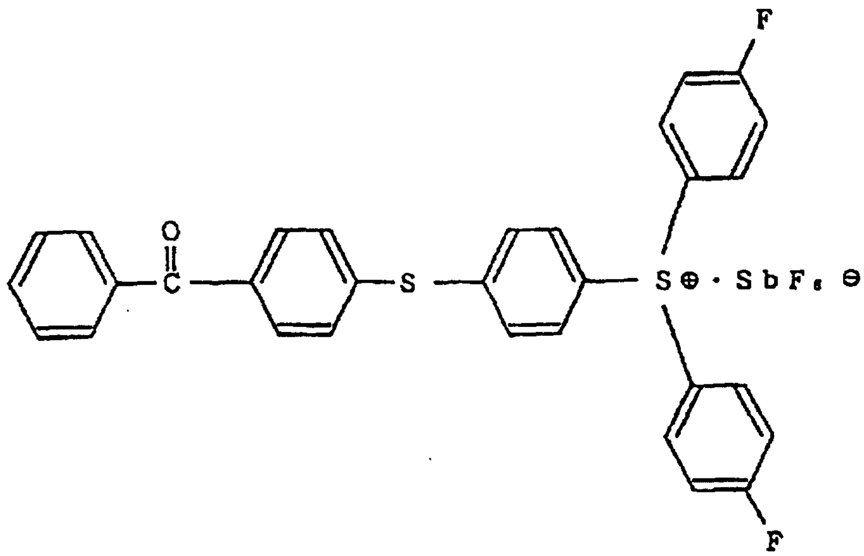

Compound (c-ii)

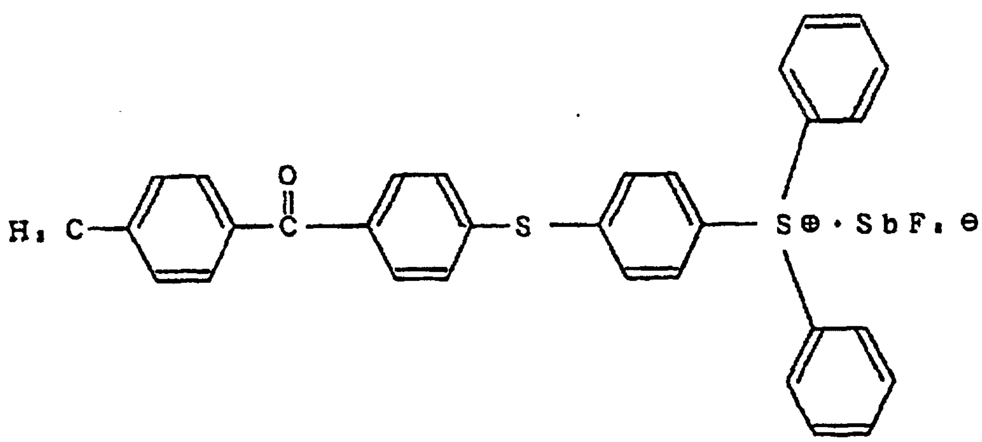

Compound (c-iii)

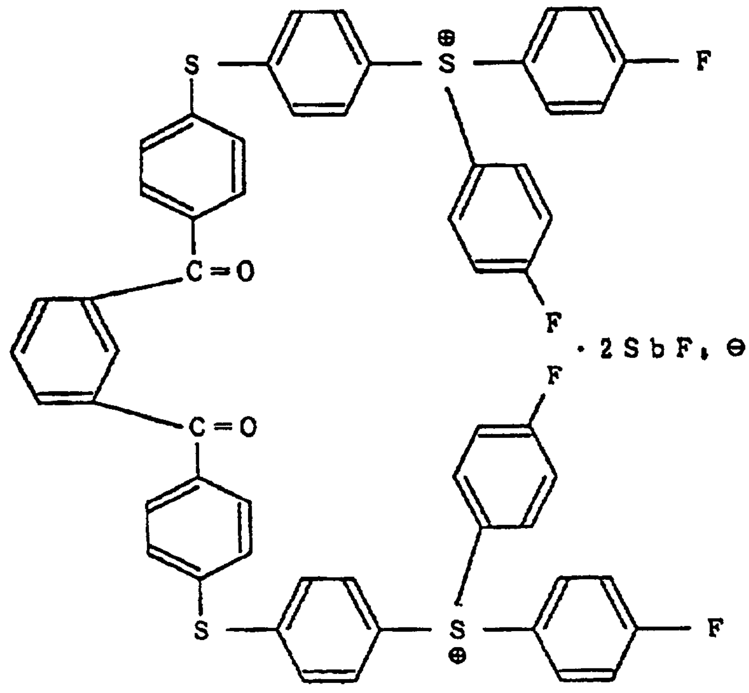

Compound (c-iv)

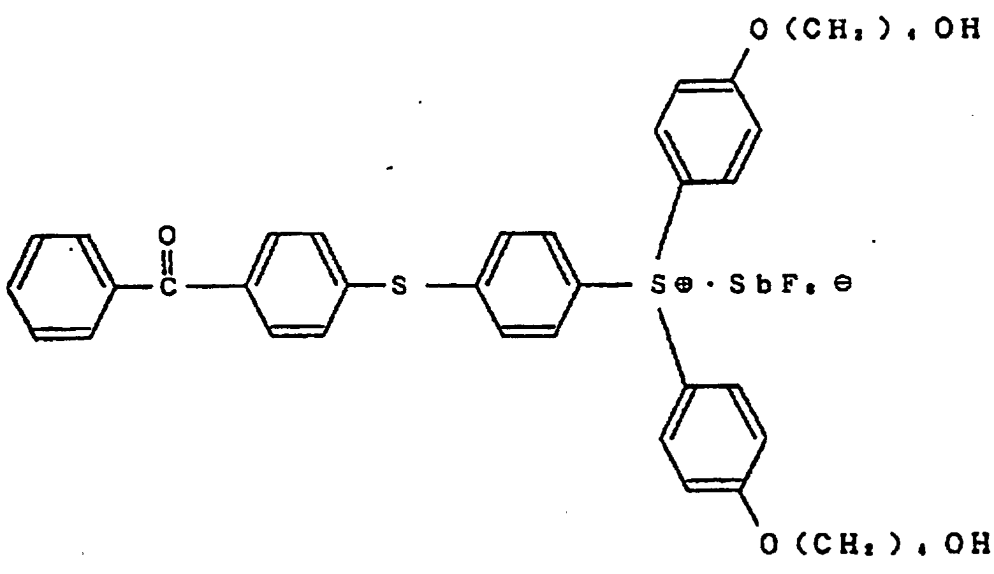

Compound (c-v)

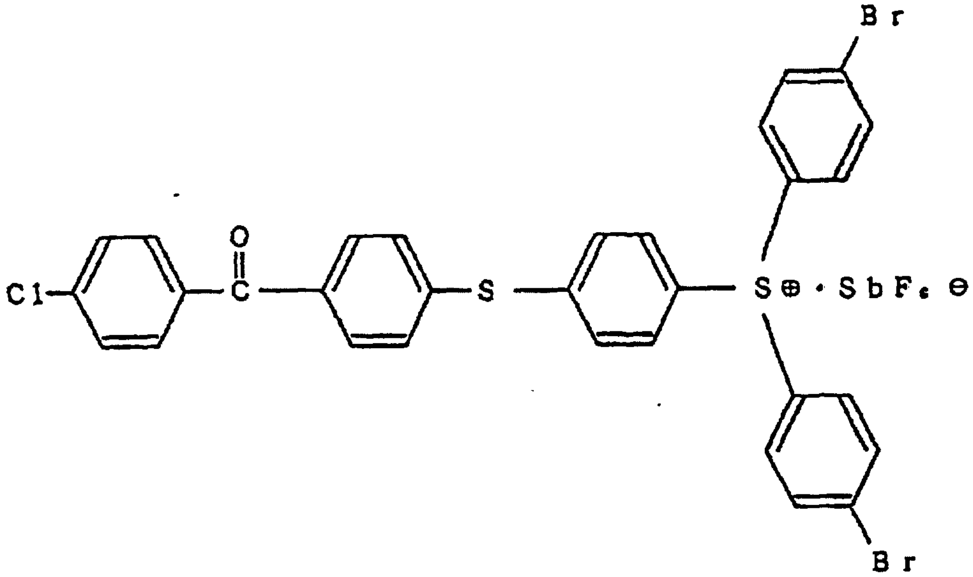

Compound (c-vi)

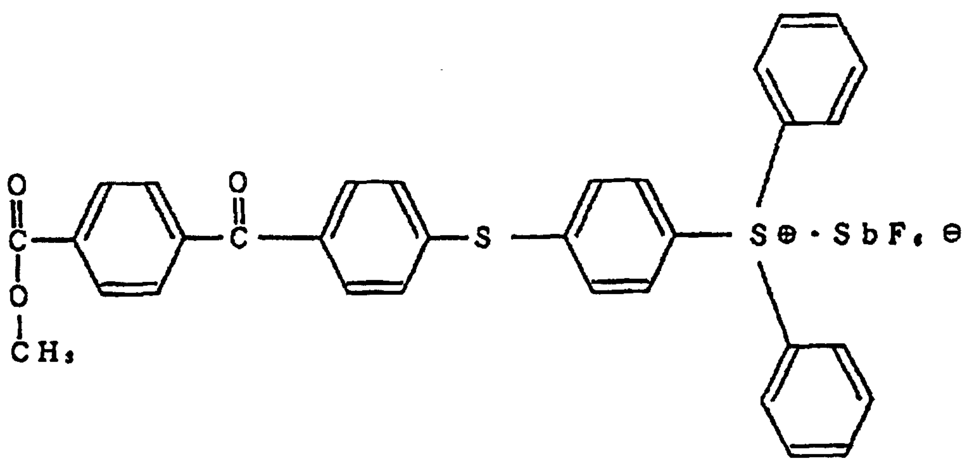

Compound (c-vii)

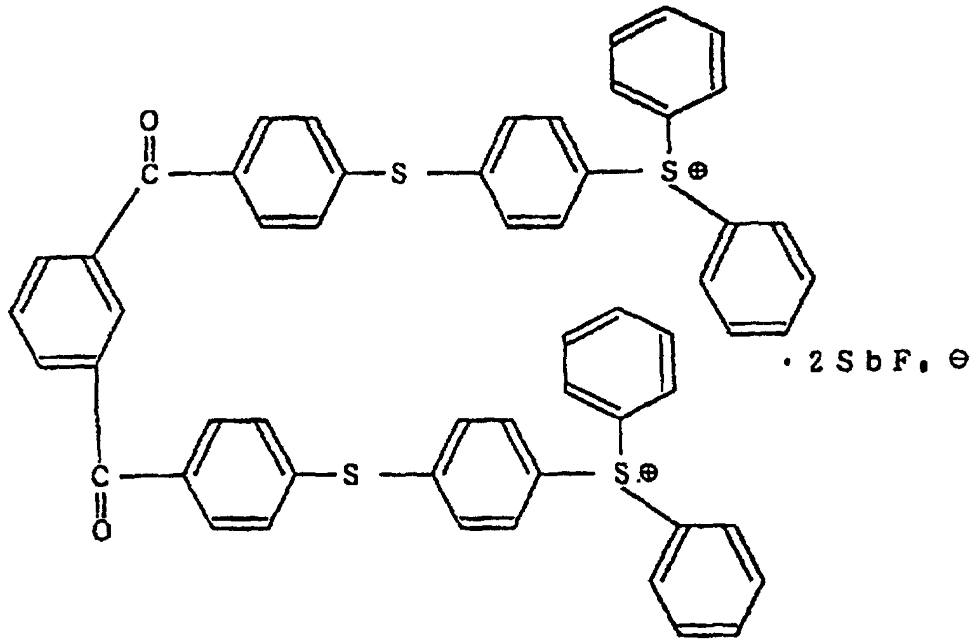

Compound (c-viii)

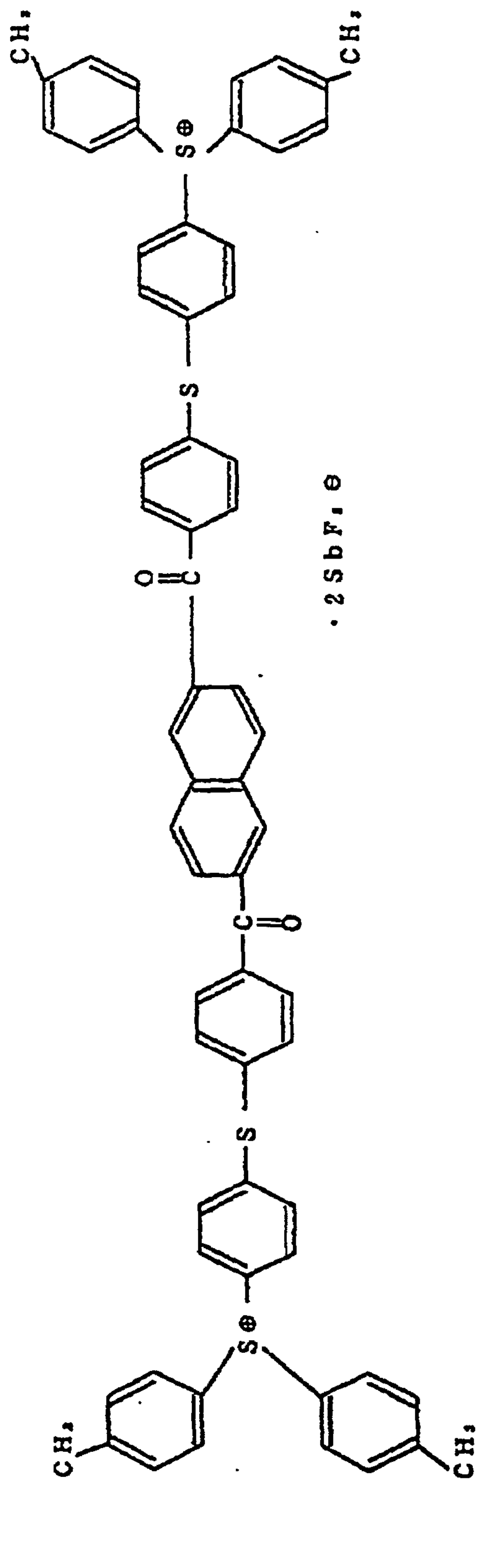

Compound (c-ix)

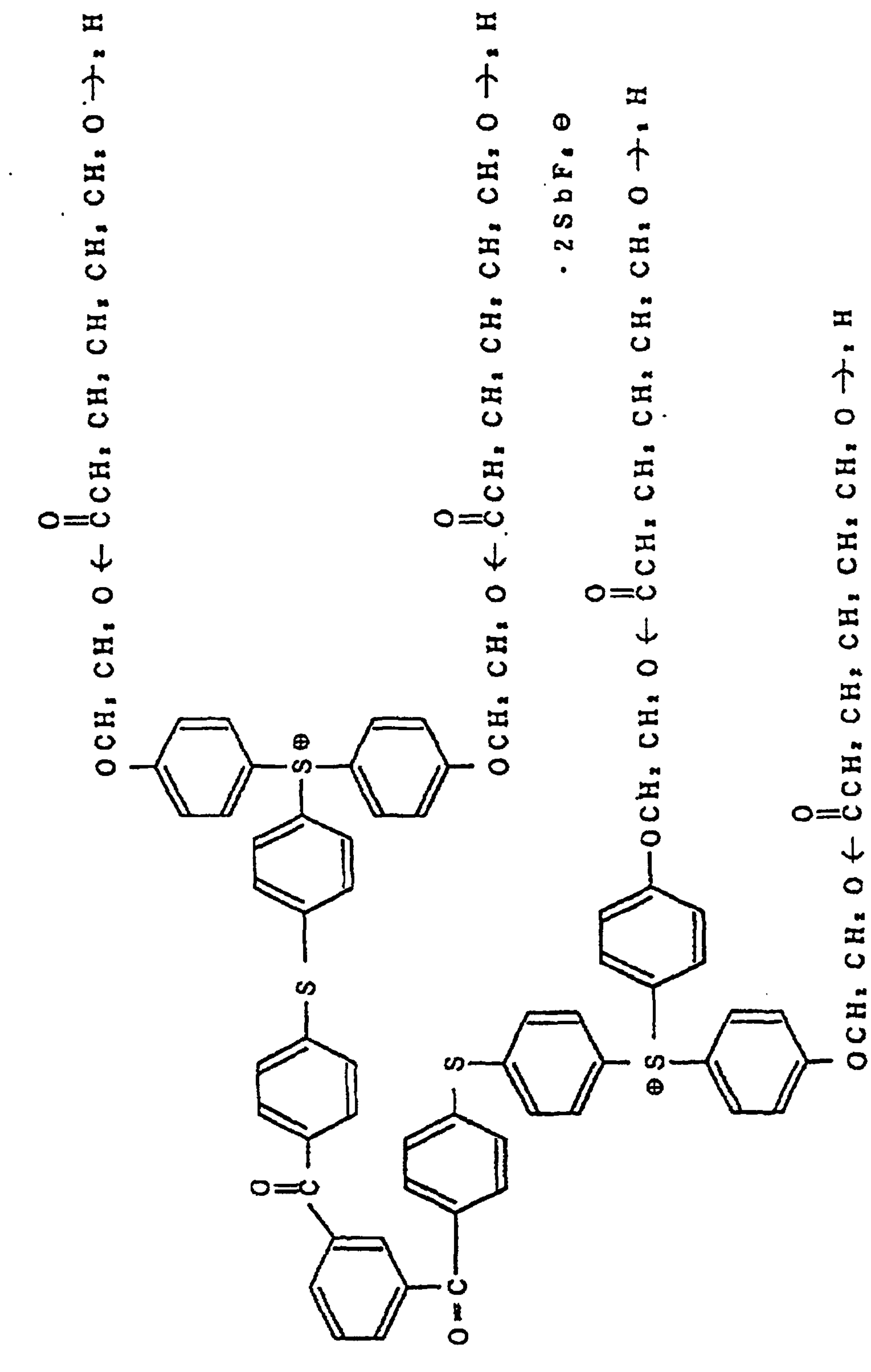

**3.** The photo-curable resin composition of claim 1, wherein component (A) is selected from the group consisting of: 3,4-epoxycyclohexylmethyl-3',4'-epoxycyclohexane carboxylate and bis(3,4-epoxycyclohexylmethyl) adipate.

**4.** The photo-curable resin composition of claim 1, wherein component (D) is a poly-functional monomer.

**5.** The photo-curable resin composition of claim 1, wherein component (F) is selected from the group consisting of a polyol having 3-6 hydroxy groups.

**6.** The photo-curable resin composition of claim 1, wherein, relative to the total weight of the composition:

(a) component (A) is present in an amount of about 30 wt.% to about 80 wt.%;
(b) component (B) is present in an amount of about 5 wt.% to about 40 wt.%.
(c) component (C) is present in an amount of about 0.1 wt.% to about 10 wt.%;
(d) component (D) is present in an amount of about 5 wt.% to about 30 wt.%
(e) component (E) is present in an amount of about 0.1 wt.% to about 8 wt.%; and
(f) component (F) is present in an amount of about 5 wt.% to about 30 wt.%

**7.** The composition of claim 1, wherein said composition has a camber value of less than 0.20 after being exposed to 50% humidity for 30 days at 23°C.

**8.** A three-dimensional object comprising a cured photo-curable reisn composition according to any one of claims 1-7.

**Patentansprüche**

**1.** Photohärtbare Harzzusammensetzung, umfassend

(A) eine Verbindung mit einer Cyclohexenoxid-Struktur,
(B) eine Verbindung mit einer Glycidylether-Struktur,
(C) ein Oniumsalz, dargestellt durch die folgende Formel (1),
(D) ein ethylenisch ungesättigtes Monomer,
(E) einen Radikal-Photoinitiator und
(F) ein Polyol mit drei oder mehr Hydroxylgruppen in einem Molekül;

Formel (1):

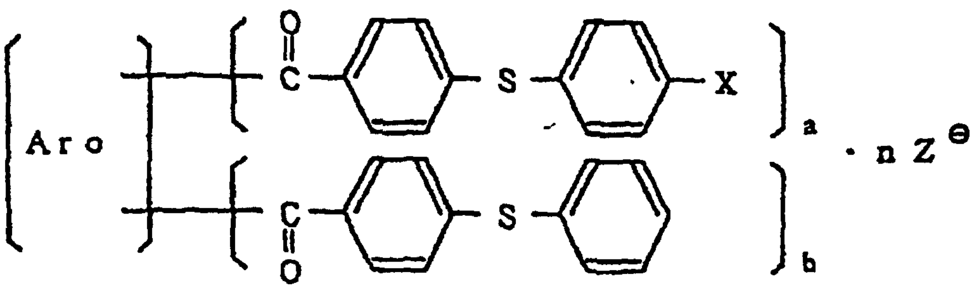

worin Aro eine aromatische Gruppe mit einer Wertigkeit von 1 bis 4 darstellt, X eine Bisphenylsulfonio-Gruppe darstellt, die eine Substitutionsgruppe enthalten kann, die durch die folgende Formel (2) dargestellt ist, und Z ein durch die folgende Formel (3) dargestelltes Halogenid darstellt, a eine ganze Zahl von 1 bis 4, b 0 oder eine ganze Zahl von 1 bis 3, die Summe von a und b eine ganze Zahl von 1 bis 4 und n eine ganze Zahl von 1 bis 4 ist;

Formel (2):

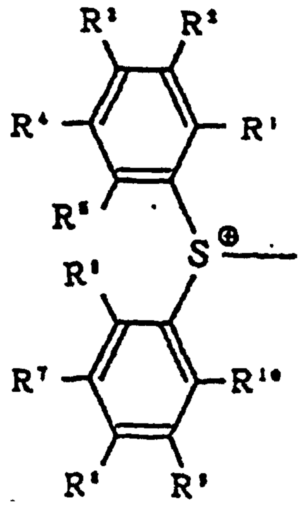

worin $R^1$-$R^{10}$ unabhängig voneinander ein Wasserstoffatom, Halogenatom, eine Nitrogruppe, Alkoxygruppe, Alkylgruppe, Phenylgruppe, die mit einer Substitutionsgruppe mit 6 bis 18 Kohlenstoffatomen substituiert sein kann, Phenoxygruppe, Phenylcarbonylgruppe, Alkylthiogruppe, Phenylthiogruppe, Benzyloxygruppe, eine aliphatische Gruppe mit 1 bis 25 Kohlenstoffatomen und zumindest einer Hydroxylgruppe oder eine aliphatische Gruppe mit 3 bis 25 Kohlenstoffatomen und einer Gruppe der Formel $-OCH_2CH(R^{11})O-$($R^{11}$ stellt ein Wasserstoffatom oder eine Alkylgruppe dar) darstellen;

Formel (3):

$$MQ_m\text{-}(\text{-}OH)_L$$

worin M ein Boratom, Phosphoratom, Arsenatom oder Antimonatom und Q ein Halogenatom darstellen und m eine ganze Zahl von 3 bis 6, L 0 oder 1 und die Summe von m + L eine ganze Zahl von 4 bis 6 ist.

2. Photohärtbare Harzzusammensetzung nach Anspruch 1, wobei das Oniumsalz aus der Gruppe ausgewählt ist, die aus den unten definierten Verbindungen c-i, c-ii, c-iii, c-iv, c-v, c-vi, c-vii, c-viii und c-ix besteht:

Verbindung (c-i)

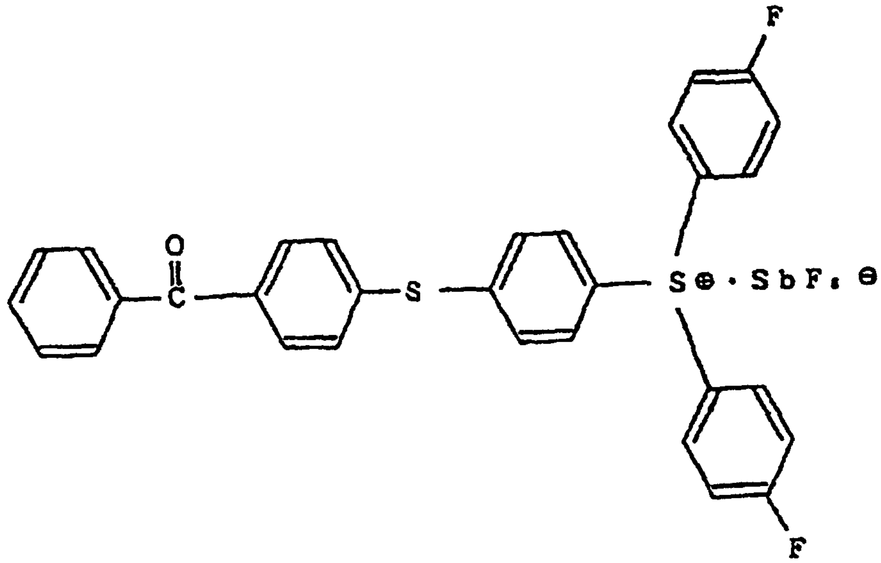

Verbindung (c-ii)

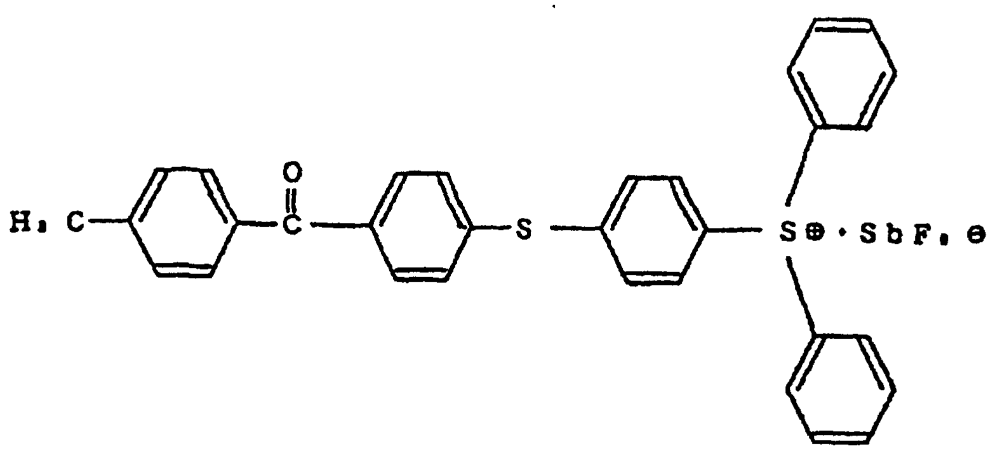

Verbindung (c-iii)

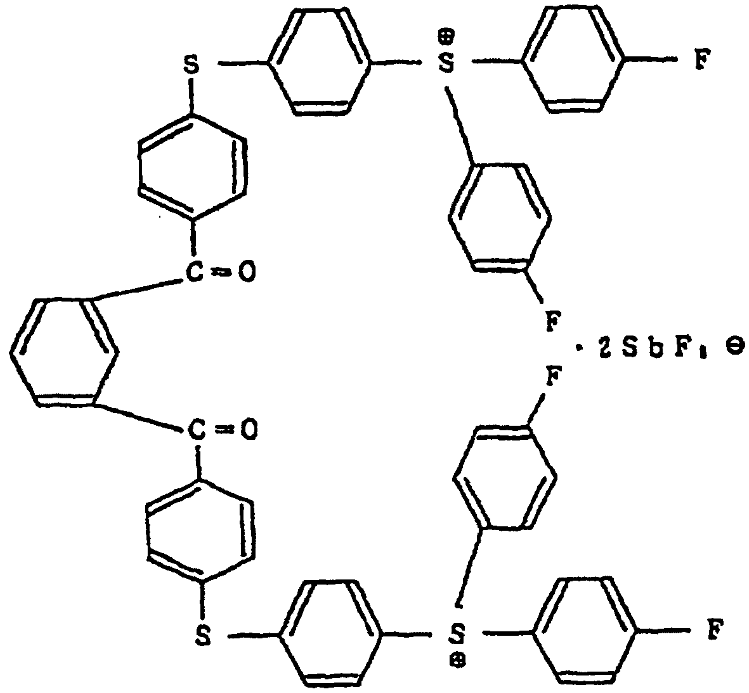

Verbindung (c-iv)

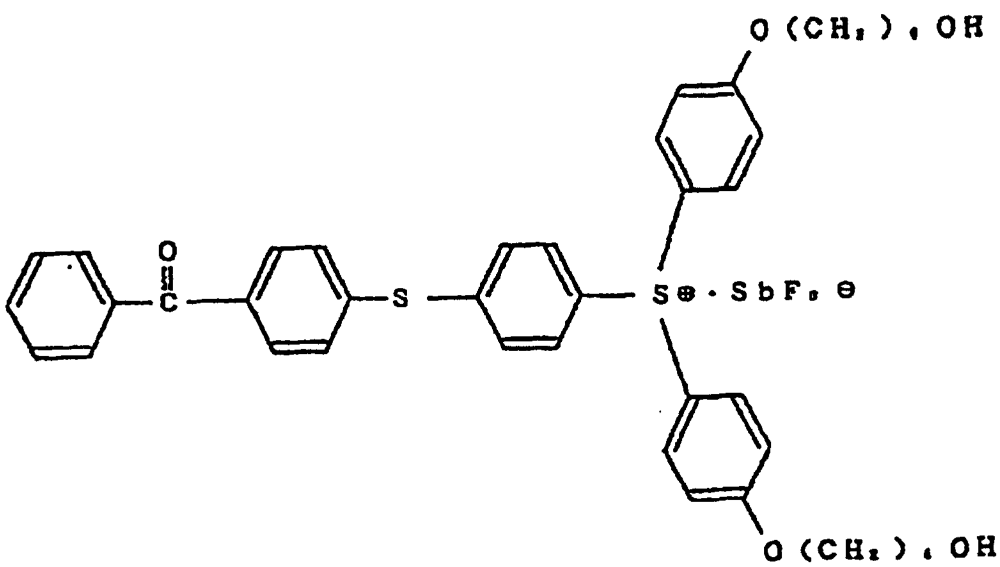

Verbindung (c-v)

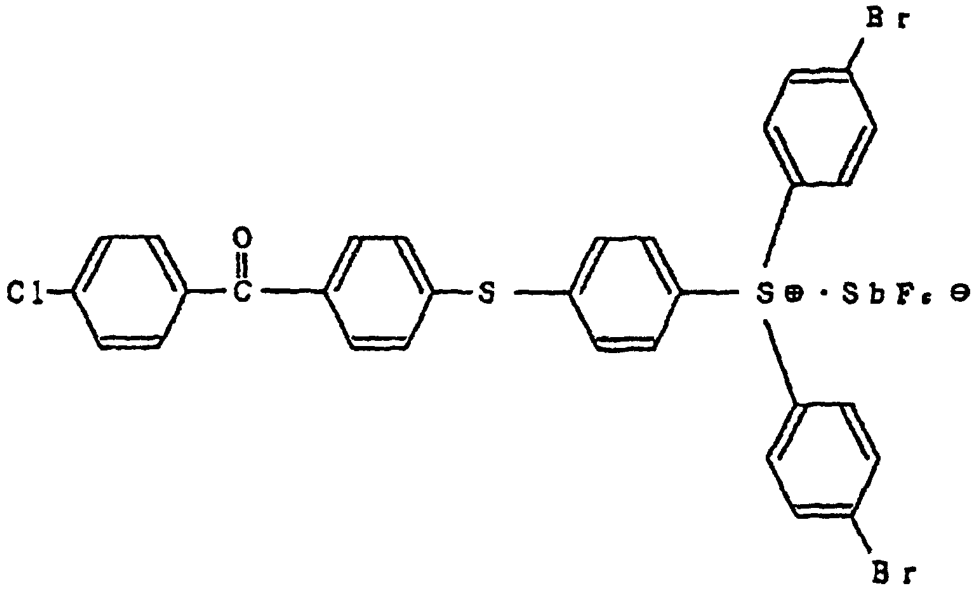

Verbindung (c-vi)

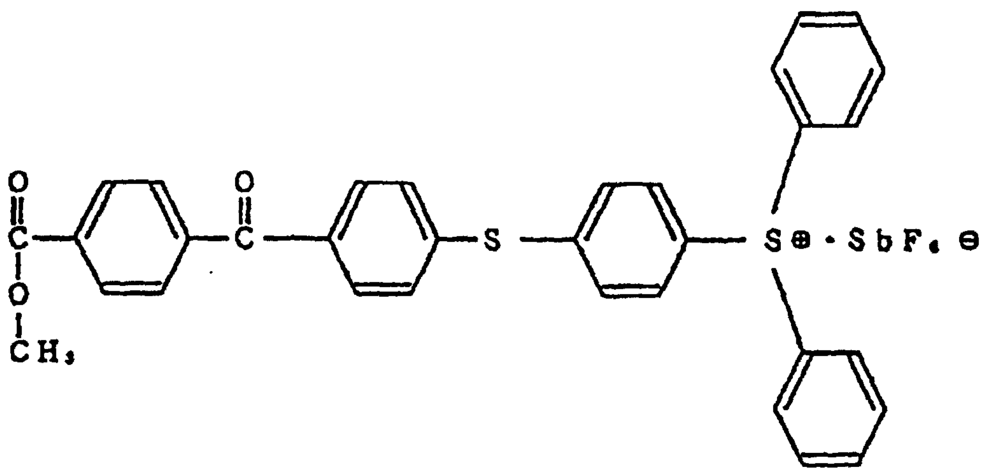

Verbindung (c-vii)

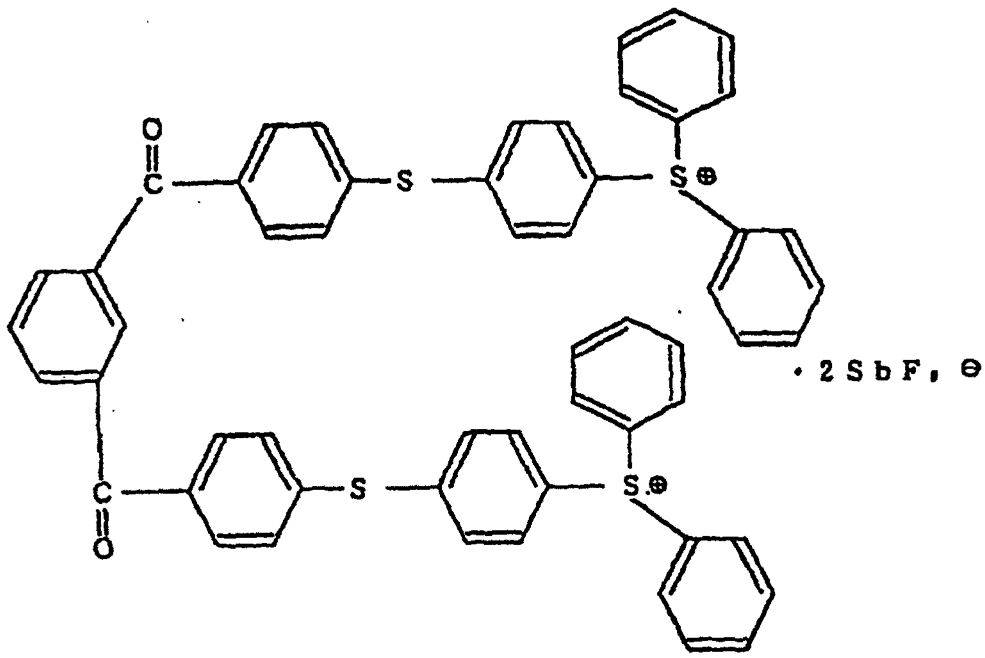

Verbindung (c-viii)

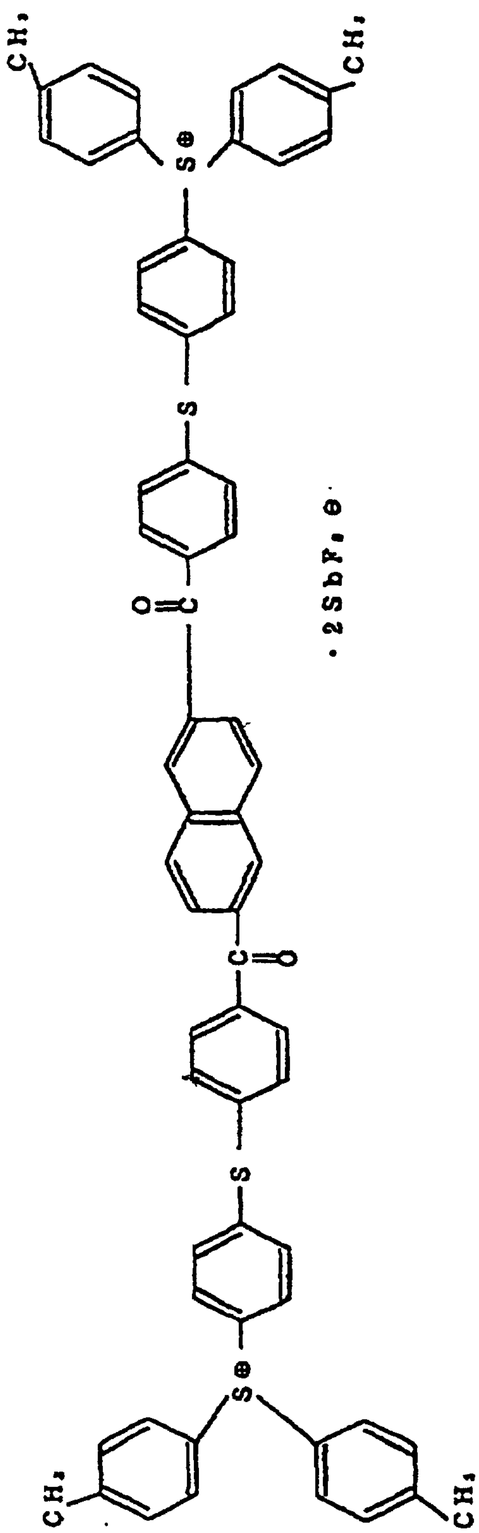

Verbindung (c-ix)

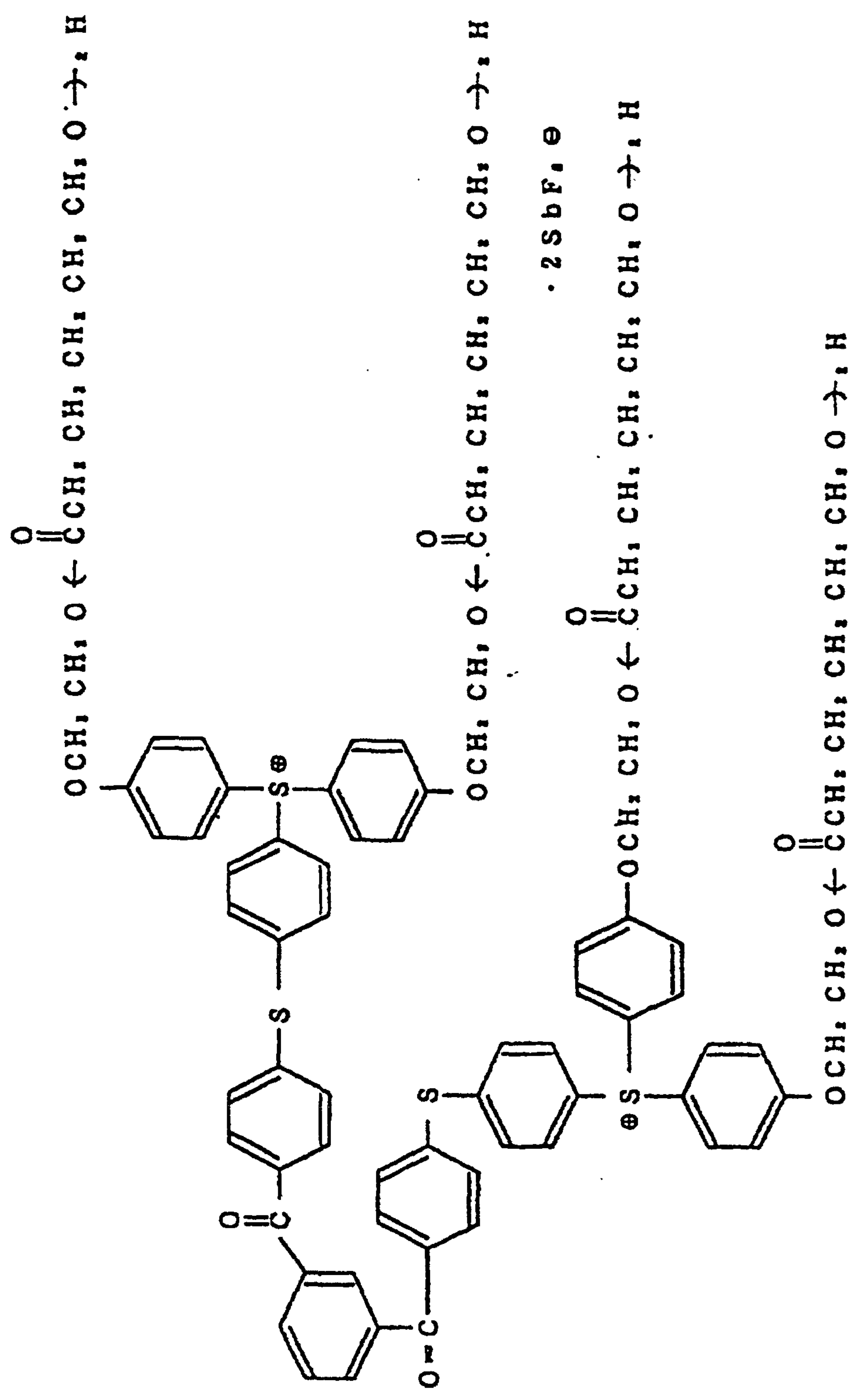

3. Photohärtbare Harzzusammensetzung nach Anspruch 1, wobei Komponente (A) aus der Gruppe ausgewählt ist, die aus 3,4-Epoxycyclohexylmethyl-3',4'-epoxycyclohexancarboxylat und Bis(3,4-epoxycyclohexylmethyl)adipat besteht.

4. Photohärtbare Harzzusammensetzung nach Anspruch 1, wobei Komponente (D) ein polyfunktionelles Monomer ist.

5. Photohärtbare Harzzusammensetzung nach Anspruch 1, wobei Komponente (F) aus der Gruppe ausgewählt ist, die aus einem Polyol mit 3 bis 6 Hydroxygruppen besteht.

6. Photohärtbare Harzzusammensetzung nach Anspruch 1, wobei in bezug auf das Gesamtgewicht der Zusammensetzung

(a) Komponente (A) in einer Menge von etwa 30 Gew.-% bis etwa 80 Gew.-% vorliegt;
(b) Komponente (B) in einer Menge von etwa 5 Gew.-% bis etwa 40 Gew.-% vorliegt;
(c) Komponente (C) in einer Menge von etwa 0,1 Gew.-% bis etwa 10 Gew.-% vorliegt;
(d) Komponente (D) in einer Menge von etwa 5 Gew.-% bis etwa 30 Gew.-% vorliegt;
(e) Komponente (E) in einer Menge von etwa 0,1 Gew.-% bis etwa 8 Gew.-% vorliegt und
(f) Komponente (F) in einer Menge von etwa 5 Gew.-% bis etwa 30 Gew.-% vorliegt.

7. Zusammensetzung nach Anspruch 1, wobei die Zusammensetzung einen Krümmungswert von weniger als 0,20 aufweist, nachdem sie 30 Tage bei 23 °C 50 % Feuchte ausgesetzt wurde.

8. Dreidimensionaler Gegenstand, umfassend eine gehärtete photohärtbare Harzzusammensetzung nach einem der Ansprüche 1 bis 7.

**Revendications**

1. Composition de résine photodurcissable comprenant :

(A) un composé ayant une structure oxyde de cyclohexène,
(B) un composé ayant une structure éther glycidylique,
(C) un sel d'onium représenté par la formule (1) suivante,
(D) un monomère éthyléniquement insaturé,
(E) un photoamorceur radicalaire, et
(F) un polyol ayant trois ou plusieurs groupes hydroxyle dans une molécule ;

Formule (1) :

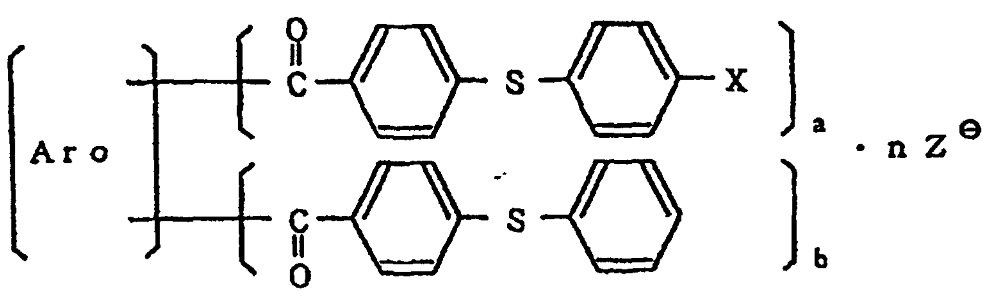

dans laquelle Aro représente un groupe aromatique avec une valence de 1 à 4, X représente un groupe bisphénylsulfonio qui peut contenir un groupe de substitution représenté par la formule (2) suivante, et Z représente un halogénure représenté par la formule (3) suivante, a est un nombre entier allant de 1 à 4, b vaut zéro ou est un nombre entier allant de 1 à 3, la somme de a et b est un nombre entier allant de 1 à 4, et n est un nombre entier allant de 1 à 4 ;

Formule (2) :

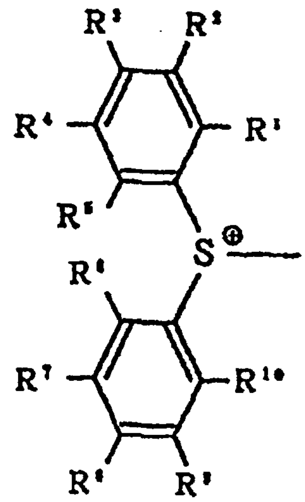

dans laquelle $R^1$ à $R^{10}$ représentent, respectivement, un atome d'hydrogène, un atome d'halogène, un groupe nitro, un groupe alcoxy, un groupe alkyle, un groupe phényle qui peut être substitué par un groupe de substitution ayant 6 à 18 atomes de carbone, un groupe phénoxy, un groupe phénylcarbonyle, un groupe alkylthio, un groupe phénylthio, un groupe benzyloxy, un groupe aliphatique ayant 1 à 25 atomes de carbone et au moins un groupe hydroxyle, ou un groupe aliphatique ayant 3 à 25 atomes de carbone et un groupe représenté par la formule $-OCH_2CH(R^{11})O-$ ($R^{11}$ représente un atome d'hydrogène ou un groupe alkyle) ;

Formule (3) :

$$MQ_m\text{-}(\text{-}OH)_L$$

dans laquelle M est un atome de bore, un atome de phosphore, un atome d'arsenic ou un atome d'antimoine, et Q est un atome d'halogène, m est un nombre entier allant de 3 à 6, L vaut 0 ou 1, et la somme de m+L est un nombre entier allant de 4 à 6.

2. Composition de résine photodurcissable selon la revendication 1, dans laquelle le sel d'onium est choisi dans le groupe formé par les composés c-i, c-ii, c-iii, c-iv, c-v, c-vi, c-vii, c-viii et c-ix, définis ci-dessous :

Composé (c-i)

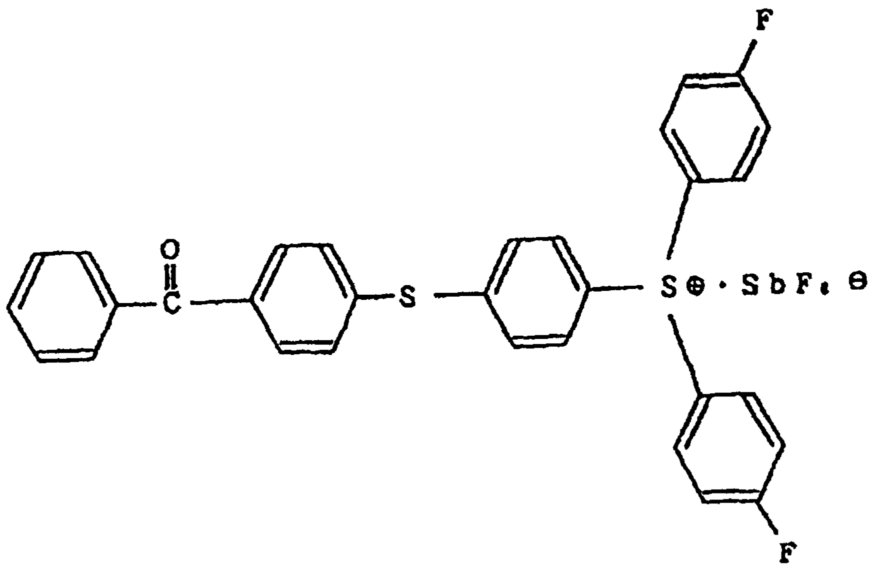

Composé (c-ii)

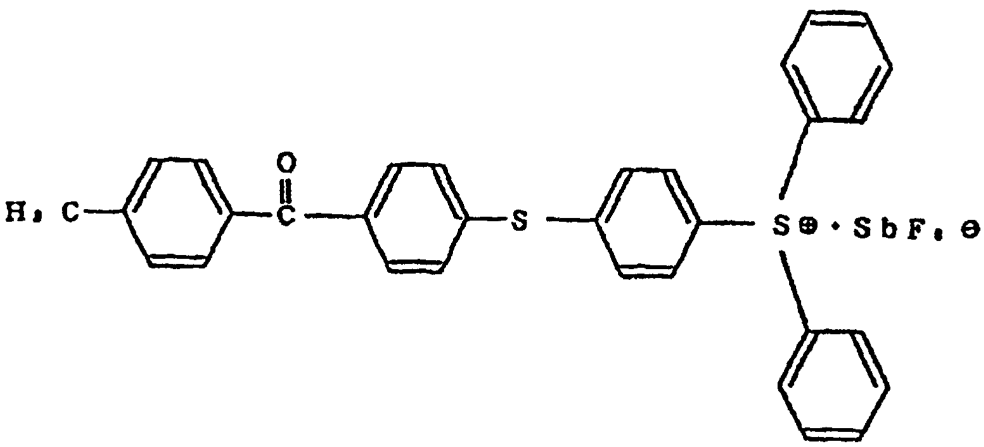

Composé (c-iii)

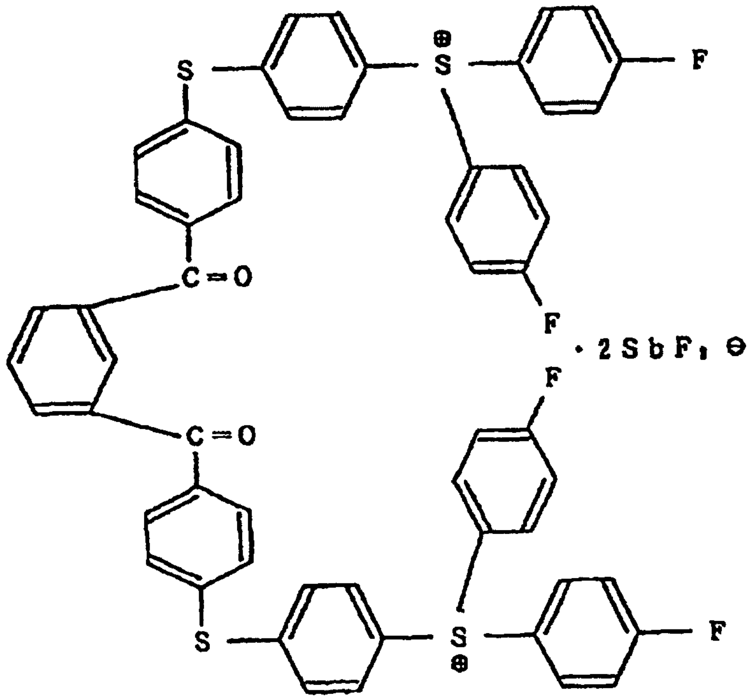

Composé (c-iv)

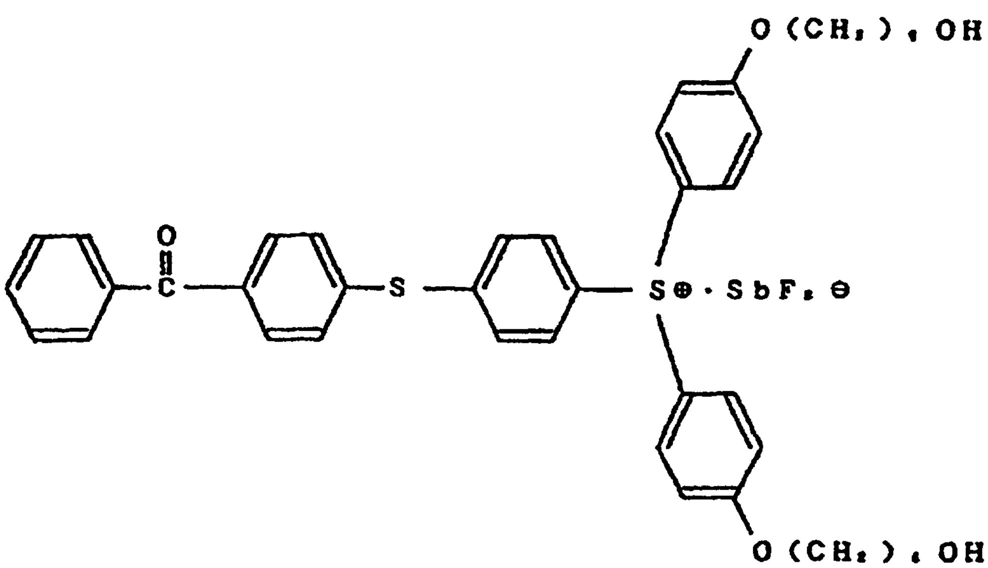

Composé (c-v)

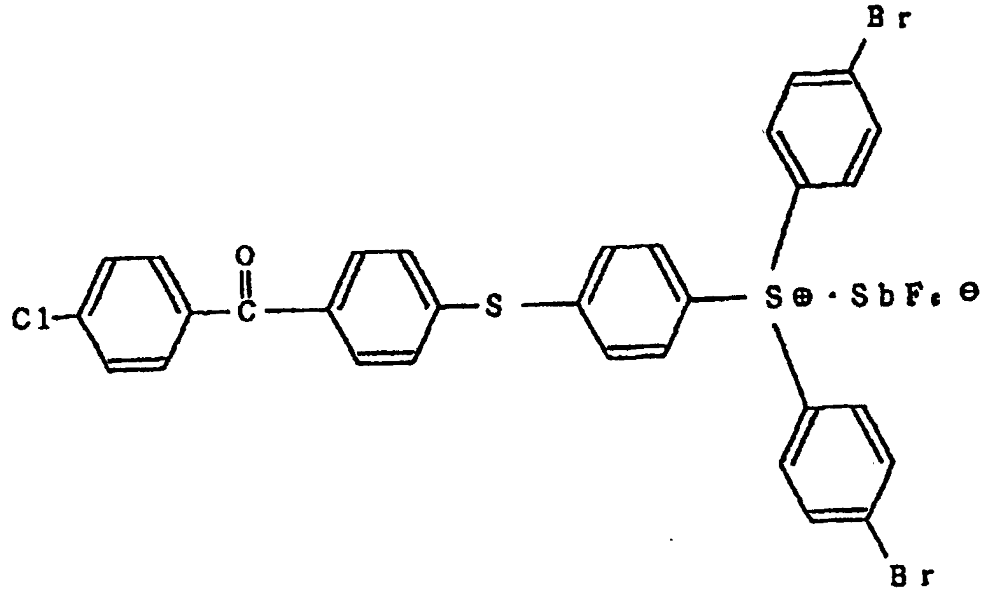

Composé (c-vi)

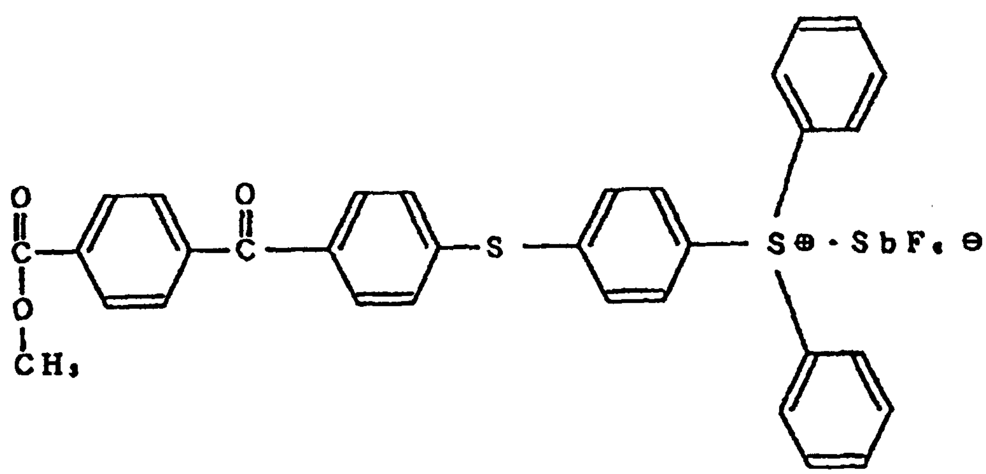

Composé (c-vii)

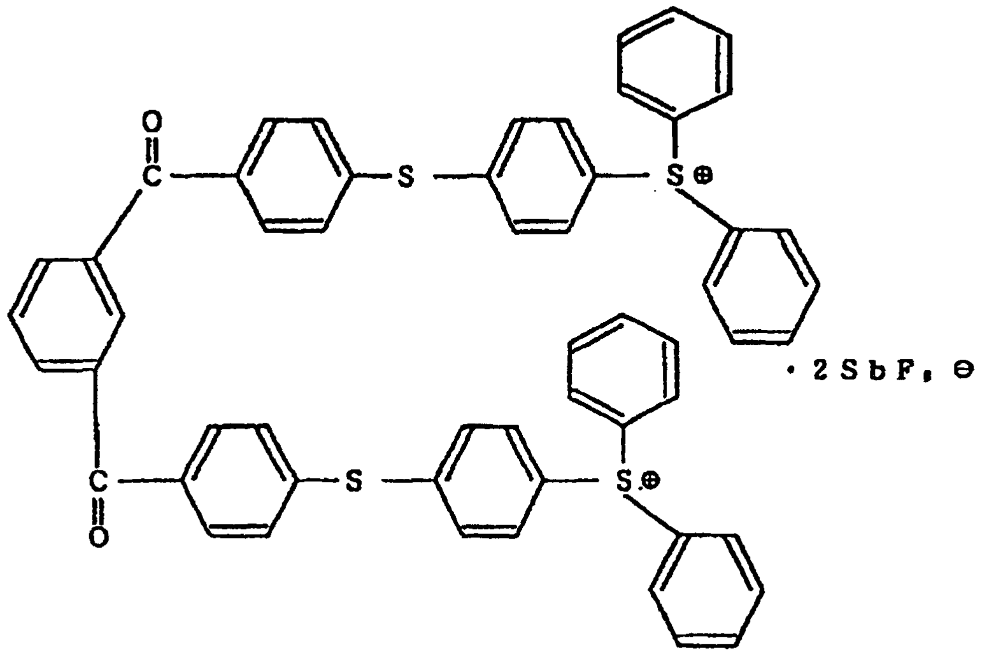

Composé (c-viii)

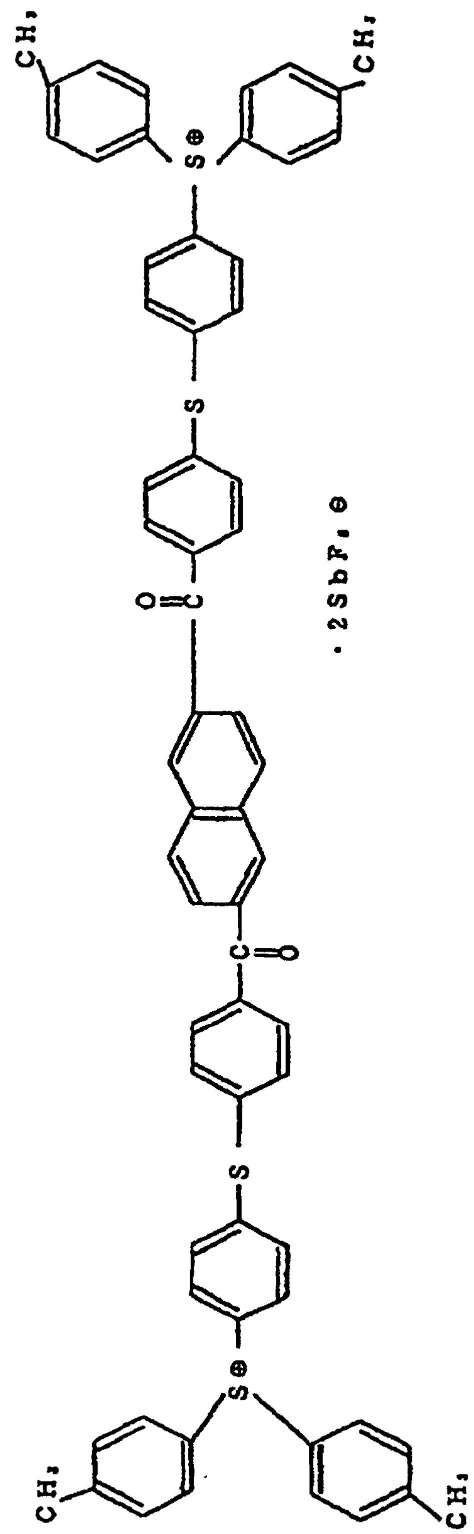

Composé (c-ix)

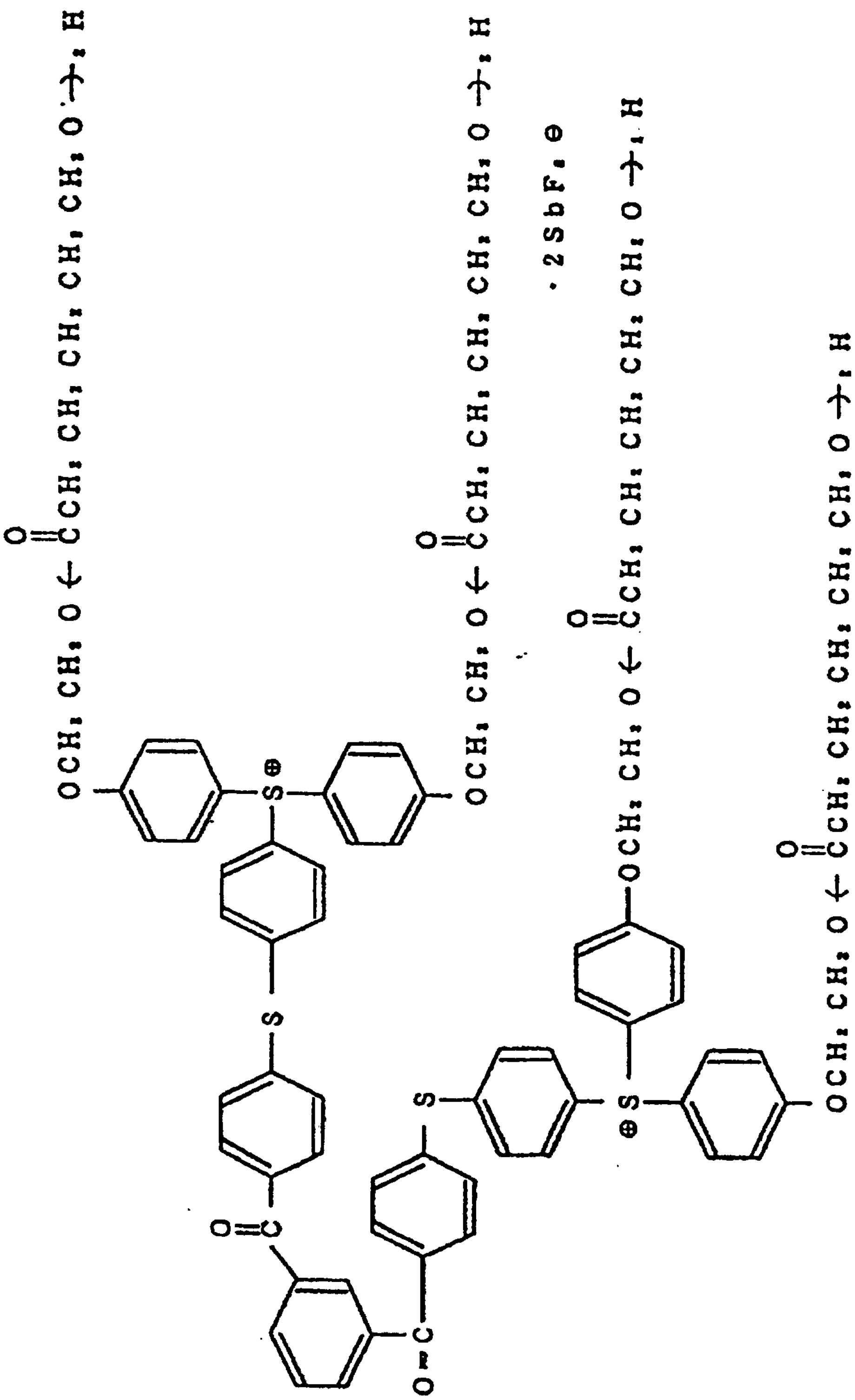

3. Composition de résine photodurcissable selon la revendication 1, dans laquelle le composant (A) est choisi dans le groupe formé par le carboxylate de 3,4-époxycyclohexylméthyl-3',4'époxycyclohexane et l'adipate de bis (3,4-époxycyclohexylméthyle).

**4.** Composition de résine photodurcissable selon la revendication 1, dans laquelle le composant (D) est un monomère polyfonctionnel.

**5.** Composition de résine photodurcissable selon la revendication 1, dans laquelle le composant (F) est choisi dans le groupe formé par un polyol ayant 3 à 6 groupes hydroxyle.

**6.** Composition de résine photodurcissable selon la revendication 1, dans laquelle, par rapport au poids total de la composition :

(a) le composant (A) est présent à raison d'environ 30% en poids à environ 80% en poids ;
(b) le composant (B) est présent à raison d'environ 5% en poids à environ 40% en poids ;
(c) le composant (C) est présent à raison d'environ 0,1% en poids à environ 10% en poids ;
(d) le composant (D) est présent à raison d'environ 5% en poids à environ 30% en poids ;
(e) le composant (E) est présent à raison d'environ 0,1% en poids à environ 8% en poids ; et
(f) le composant (F) est présent à raison d'environ 5% en poids à environ 30% en poids.

**7.** Composition selon la revendication 1, dans laquelle ladite composition possède une valeur de cambrure inférieure à 0,20 après avoir été exposée à une humidité de 50% pendant 30 jours à 23°C.

**8.** Objet tridimensionnel comprenant une composition de résine photodurcissable selon l'une quelconque des revendications 1 à 7.

(1)

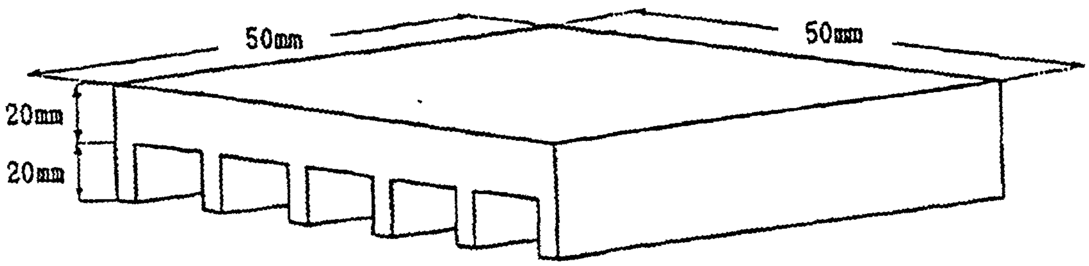


(2)